(19) Europäisches Patentamt / European Patent Office / Office européen des brevets

(11) **EP 4 576 094 B1**

(12) **FASCICULE DE BREVET EUROPEEN**

(45) Date de publication et mention de la délivrance du brevet:
**15.04.2026 Bulletin 2026/16**

(21) Numéro de dépôt: **24221217.3**

(22) Date de dépôt: **18.12.2024**

(51) Classification Internationale des Brevets (IPC):
**G11C 11/54** *(2006.01)*   **G06N 3/063** *(2023.01)*
**G11C 13/00** *(2006.01)*

(52) Classification Coopérative des Brevets (CPC):
**G11C 13/004; G06N 3/063; G11C 11/54;**
G11C 7/1006

(54) **CIRCUIT ÉLECTRONIQUE À BASE DE CELLULES RRAM 2T2R AVEC PRÉCISION AMÉLIORÉE**

ELEKTRONISCHE SCHALTUNG AUF RRAM 2T2R-ZELLENBASIS MIT VERBESSERTER GENAUIGKEIT

2T2R RRAM CELL-BASED ELECTRONIC CIRCUIT WITH IMPROVED ACCURACY

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **19.12.2023 FR 2314511**

(43) Date de publication de la demande:
**25.06.2025 Bulletin 2025/26**

(73) Titulaire: **Commissariat à l'Energie Atomique et aux Energies Alternatives
75015 Paris (FR)**

(72) Inventeur: **EZZADEEN, Mona
38054 GRENOBLE CEDEX 9 (FR)**

(74) Mandataire: **Lavoix
2, place d'Estienne d'Orves
75441 Paris Cedex 09 (FR)**

(56) Documents cités:
**US-A1- 2023 059 091**

**Description**

La présente invention concerne un circuit électronique propre à mettre en œuvre des opérations de calcul fournissant chacune une sortie binaire.

L'invention concerne tout type d'application utilisant des opérations appliquées à des opérandes binaires, notamment des applications utilisant des réseaux de neurones artificiels binaires, également appelés BNN (de l'anglais *Binary Neural Network*).

Un réseau de neurones est généralement composé d'une succession de couches de neurones dont chacune prend ses entrées sur les sorties de la couche précédente. Plus précisément, chaque couche comprend des neurones prenant leurs entrées sur les sorties des neurones de la couche précédente. Chaque couche est reliée à la suivante par une pluralité de synapses. Un poids synaptique est associé à chaque synapse. C'est un nombre, tel qu'un nombre binaire, ou encore une distribution, qui prend des valeurs positives comme négatives. Dans le cas d'une couche dense, l'entrée d'un neurone est la somme pondérée des sorties des neurones de la couche précédente, la pondération étant faite par les poids synaptiques et suivie d'une activation via une fonction d'activation.

Il est donc souhaitable de développer des architectures matérielles dédiées, entremêlant mémoire et calcul, pour réaliser des réseaux de neurones rapides, à faible consommation et capables d'apprendre en temps réel.

De telles architectures matérielles dédiées visent plus généralement à effectuer efficacement des opérations appliquées à des opérandes binaires.

Il est connu un réseau de neurones reposant sur des technologies de type optique.

Un autre champ de recherche porte sur la réalisation de neurones et de synapses de réseaux de neurones sur la base d'une technologie de type CMOS (de l'anglais *Complementary Metal-Oxide-Semiconductor*). Le sigle CMOS désigne aussi bien un procédé de fabrication qu'un composant obtenu par un tel procédé de fabrication.

Toutefois, selon chacune de ces technologies, chaque neurone occupe plusieurs dizaines de micromètres de côté. En outre, chaque synapse occupe également plusieurs dizaines de micromètres de côté. Il en résulte que, sur une surface limitée correspondant par exemple à une puce électronique, le nombre de neurones et de synapses qui peuvent être intégrés est limité, ce qui résulte en une diminution des performances du réseau de neurones.

De ce fait, pour diminuer l'encombrement, il est spécifiquement étudié des architectures dans lesquelles les synapses sont memristives.

Des synapses memristives sont des synapses utilisant des memristors. En électronique, le memristor (ou memristance) est un composant électronique passif. Le nom est un mot-valise formé à partir des deux mots anglais memory et resistor. Un memristor est un composant de mémoire non-volatile, la valeur de sa résistance électrique changeant avec l'application d'une tension pendant une certaine durée et restant à cette valeur en l'absence de tension.

Des exemples d'une telle implémentation sont proposés dans les documents suivants.

La demande publiée US 2023/059091 A1 montre un exemple de synapses memristives.

L'article *"A compute-in-memory chip based on resistive random-access memory"* de W. Wan et al, publié dans Nature en 2022, décrit une technique classique consistant à encoder les poids binaires en tant qu'état résistif au sein de cellules mémoires (un état résistif haut (HRS) pour coder le 1, et un état résistif bas (LRS) pour coder le 0 par exemple), et à appliquer les activations d'entrée sur la ligne de bit ou BL (de l'anglais *Bit Line)* de chaque cellule. Il en résulte, via la loi d'Ohm, un courant dans chaque cellule qui est proportionnel à la multiplication entre les poids et les entrées, qui est sommé via les lois de Kirchhoff sur la ligne de source ou SL (de l'anglais *Source Line*) commune. Le courant de la ligne de source est alors proportionnel à la multiplication-accumulation (MAC) entre les activations d'entrées et leur poids respectifs. Cette approche est très sensible à la variabilité des cellules mémoires, qui n'est pas négligeable pour la majorité des mémoires résistives. Cette variabilité influence directement le courant de multiplication au sein de chaque cellule mémoire, s'accumule en bout de colonne via la loi de Kirchhoff et rend d'autant plus difficile la lecture du résultat de la multiplication-accumulation que le nombre de cellules activées est grand. Il en résulte un circuit de lecture complexe et de grande surface, ainsi qu'une limitation de la taille de la matrice de cellules mémoire due à un nombre maximum de cellules activées en parallèle au-delà duquel la lecture devient impossible à cause de la variabilité. Le nombre maximal d'entrées activées en parallèle pour cette technique est typiquement de 256, et nécessite alors en outre un circuit d'entrainement complexe et l'inclusion d'un ordinateur dans la boucle d'entrainement pour s'adapter aux spécificités de chaque puce, ce qui le rend incompatible avec des contraintes de l'internet des objets. De manière plus générale, le nombre maximal d'entrées activées en parallèle se situe plutôt autour de 9 entrées.

L'article *"Efficient and Robust Nonvolatile Computing-In-Memory Based on Voltage Division in 2T2R RRAM With Input-Dependent Sensing Control"* de L. Wang et al, publié en mai 2021, décrit une technique plus robuste face à la variabilité en connectant les poids aux entrées de manière à former un pont résistif. Cette approche se base sur un ratio de poids complémentaires, plus robuste face à la variabilité des cellules résistives. De plus, dans chaque cellule mémoire 2T2R, le courant passe toujours par une somme de résistances LRS et HRS en série, au lieu d'une seule résistance LRS ou HRS selon la technique classique précitée. Cette approche permet alors une réduction de la consommation de courant. Cependant, cette technique reste sensible à la variabilité des cellules résistives, limitant également son utilisation fiable à des neurones à 9 entrées.

L'article "A crossbar array of magnetoresistive memory devices for in-memory computing" de S. Jung et al, publié dans Nature en 2022, décrit une autre approche consistant à connecter les poids résistifs en série, au lieu de les connecter en parallèle. Les poids sont stockés dans des cellules mémoire 2T2R dont les deux transistors sont activés de manière différentielle. L'opération de multiplication entre une entrée et un poids se fait en appliquant l'entrée sur une ligne de mot ou WL (de l'anglais *Word Line*) de la cellule 2T2R, sélectionnant ainsi seulement un des deux éléments résistifs, dont la valeur est donnée par le poids. Une tension est appliquée à l'une des extrémités de la série de poids, ce qui permet de générer un courant pondéré correspondant à la multiplication-accumulation entre les poids et les entrées. Ce courant charge une capacité en bas de colonne. La tension de la capacité est comparée à une référence dans le temps, permettant ainsi de numériser la valeur de la multiplication-accumulation sur plusieurs bits.

La connexion de tous les poids en série permet de diminuer la consommation de courant comparé aux deux précédentes approches. Cependant, les transistors d'accès étant également connectés en série avec les poids, ils doivent être de grande taille pour ne pas interférer avec le calcul. De plus, cette approche reste très sensible à la variabilité des cellules résistives, avec une taille de neurone maximale de l'ordre de 64 entrées, et peut en outre souffrir d'erreurs de délais qui dépendent de la combinaison de poids activée.

L'article "Low-Overhead Implementation of Binarized Neural Networks Employing Robust 2T2R Resistive RAM Bridges" de M. Ezzadeen et al, publié en septembre 2021, et le document EP 4 137 999 A1 décrivent une dernière approche visant à supprimer l'impact de la variabilité des cellules résistives sur la précision de l'opération de multiplication-accumulation. Les poids sont stockés de manière différentielle dans des cellules mémoire 2T2R, et les entrées sont appliquées de manière différentielle sur des paires de lignes de bit complémentaires BL, BLb (de l'anglais *Bit Line*). De ce fait, les poids du neurone sont stockés dans une ligne mémoire, au lieu d'une colonne. L'application des entrées sur les lignes de bit complémentaires BL, BLb génère la création d'un pont résistif par cellule mémoire 2T2R, dont le point milieu est la ligne de source SL. La tension de la ligne de source est amplifiée et numérisée grâce à un inverseur, dont la sortie correspond alors au résultat de la multiplication. La combinaison de l'utilisation de la cellule mémoire 2T2R dans une configuration de pont résistif combiné à un inverseur offre une très grande robustesse pour le calcul de la multiplication. L'accumulation est effectuée grâce à un pont capacitif connecté en sortie des inverseurs, lequel est également très robuste par construction. La comparaison du résultat de l'accumulation au seuil du neurone se fait grâce à un comparateur. Cette approche a été démontrée robuste pour implémenter des neurones de tailles pouvant aller jusqu'à 513 entrées, voire plus.

La limite de cette approche devient alors la précision du comparateur, et non plus la variabilité des cellules mémoire. En effet, avec un neurone de 513 entrées, la différence de tension minimale aux bornes du comparateur est de l'ordre de 2mV, ce qui est un seuil relativement critique pour la conception d'un comparateur. Implémenter des neurones plus grands reviendrait à diminuer encore cette différence de tension, ce qui rendrait le comparateur plus susceptible de générer des erreurs.

Il existe donc un besoin pour un circuit électronique permettant notamment de réaliser un réseau de neurones binaire avec des cellules mémoire résistives et pour des neurones de taille plus importante, c'est-à-dire avec un nombre plus élevé d'entrées.

A cet effet, l'invention a pour objet un circuit électronique propre à mettre en œuvre des opérations de calcul fournissant chacune une sortie binaire, le circuit comprenant :

- des lignes de mot ;
- des paires de lignes de bit complémentaires ;
- des lignes de source ;
- un ensemble de cellules mémoire organisées selon une matrice comportant des rangées et des colonnes, les cellules mémoire d'une même rangée étant sélectionnables par une ligne de mot, les cellules mémoire d'une même colonne étant reliées à une paire de lignes de bit complémentaires et à une ligne de source ;
  chaque cellule mémoire comprenant deux memristors et deux commutateurs, chaque memristor étant relié à la même ligne de source et à un commutateur respectif, chaque memristor mémorisant respectivement un poids ou l'inverse du même poids en présentant respectivement des première et deuxième valeurs de résistances différentes ; les commutateurs étant reliés, pour leur activation, à une ligne de mot respective et reliés respectivement à une paire de lignes de bit complémentaires ;
- un dispositif de lecture mis en œuvre lors de chaque opération de calcul, le dispositif de lecture comportant :

  + une unité logique pour chaque colonne, chaque unité logique comprenant une borne d'entrée connectée à une ligne de source respective pour recevoir une valeur d'entrée, l'unité logique étant configurée pour effectuer une opération logique présentant un basculement entre une valeur basse et une valeur haute en fonction uniquement de la valeur de l'entrée de l'unité logique qui est connectée à la ligne de source lors de ladite opération de calcul,
  + un module de conversion configuré pour convertir un nombre de valeurs hautes ou basses en sortie des unités logiques en une grandeur intermédiaire dépendant dudit nombre de valeurs hautes ou basses en sortie des unités logiques, la grandeur intermédiaire est une grandeur électrique, telle qu'une tension électrique, dont la variation au cours du temps dépend d'une constante de temps, et la valeur de la constante de temps est fonction du nombre de valeurs hautes ou basses en sortie des unités logiques, le module de conversion comportant un ensemble de mêmes éléments reliés entre eux et un ensemble de commutateurs, chaque élément étant associé à la sortie d'une unité logique respective, chaque commutateur étant connecté en sortie d'une unité logique respective et configuré pour activer, ou respectivement inhiber, l'élément correspondant selon la valeur haute ou basse en sortie de l'unité logique respective, et la valeur de la constante de temps dépendant du nombre d'éléments activés, et

+ un module de comparaison configuré pour comparer la grandeur intermédiaire à une grandeur de référence et pour émettre en sortie un signal numérique sur un bit, dépendant de la comparaison et correspondant à la sortie du circuit électronique, le signal émis étant représentatif du résultat de l'opération de calcul.

Le circuit électronique selon l'invention offre alors l'avantage de la dernière approche précitée ne présentant pas de problème de variabilité des cellules mémoire, tout en n'ayant pas de limite de précision, la précision étant indépendante de la taille du neurone avec le circuit électronique selon l'invention, ainsi que cela sera expliqué plus en détail par la suite.

Suivant d'autres aspects avantageux de l'invention, le circuit électronique comprend une ou plusieurs des caractéristiques suivantes, prises isolément ou suivant toutes les combinaisons techniquement possibles :

- la valeur de la constante de temps est directement proportionnelle au nombre de valeurs hautes ou basses en sortie des unités logiques ;
- la valeur de la constante de temps est égale au produit d'une capacité et d'une résistance, l'une parmi la capacité et la résistance étant prédéfinie, et l'autre parmi la capacité et la résistance dépendant du nombre de valeurs hautes ou basses en sortie des unités logiques ;
- chaque élément étant de préférence une résistance ou un condensateur ;
- l'ensemble de mêmes éléments est placé entre un premier potentiel d'alimentation et un nœud intermédiaire, et le module de conversion comporte en outre un élément complémentaire placé entre le noeud intermédiaire et un second potentiel d'alimentation ;
- lorsque chaque élément est un condensateur, l'élément complémentaire est une résistance ;
- lorsque chaque élément est une résistance, l'élément complémentaire est un condensateur ;
- le module de comparaison est configuré pour transformer la grandeur intermédiaire en un signal créneau avec un front de changement d'état à un instant temporel caractéristique, l'instant temporel caractéristique étant alors comparé à un instant temporel de référence associé à la grandeur de référence, et le signal représentatif du résultat de l'opération de calcul dépendant alors de ladite comparaison
- la grandeur intermédiaire est transformée en le signal créneau via un comparateur ;
- le module de comparaison comporte le comparateur et un générateur de tension de comparaison, et le comparateur est apte à comparer la tension générée à la tension de comparaison issue du générateur de tension de comparaison ;
- l'instant temporel caractéristique est comparé à l'instant temporel de référence via une bascule ou via un comparateur avec une référence d'horloge ;
- l'instant temporel de référence est obtenu via un ensemble de mêmes deuxièmes éléments reliés entre eux et un ensemble de deuxièmes commutateurs, les deuxièmes éléments étant les mêmes que ceux de l'ensemble du module de conversion, chaque deuxième élément étant associé à la sortie d'une unité logique respective, chaque deuxième commutateur étant connecté en sortie d'une unité logique respective et configuré pour activer, ou respectivement inhiber, le deuxième élément correspondant selon la valeur haute ou basse en sortie de l'unité logique respective, et chaque deuxième commutateur étant commandé de manière inversée par rapport au commutateur du module de conversion qui est connecté en sortie de la même unité logique respective ; chaque deuxième élément étant de préférence une résistance ou un condensateur ;
- chaque unité logique réalise une fonction logique de type inverseur lors de l'opération de calcul ;
- l'opération logique effectuée par l'unité logique est une inversion, et l'opération de calcul est une opération de calcul neuronal, telle que l'opération MAC ;
- le circuit électronique est un circuit neuromorphique propre à mettre en œuvre un réseau de neurones à sortie binaire, chaque cellule mémoire étant associée à un poids synaptique respectif d'un neurone, et chaque paire de lignes de bits complémentaires étant apte à recevoir des tensions d'entrée complémentaires lors d'une opération de calcul neuronal ;
- le circuit électronique comprend un premier contrôleur permettant de sélectionner les cellules mémoire d'une rangée qui sont reliées à une même ligne de mot, et comprenant un deuxième contrôleur relié aux paires de lignes de bit et permettant d'appliquer sur chaque paire de ligne de bit des tensions différentes et symétriques par rapport à une tension milieu, la tension appliquée sur une ligne de bit étant supérieure ou inférieur à celle appliquée sur la ligne de bit complémentaire associée ;

- le circuit électronique comprend plusieurs ensembles distincts de cellules mémoire propres à fonctionner en parallèle avec un même ensemble de paires de lignes de bit complémentaires et des ensembles distincts de lignes de mot, chaque ensemble de cellules mémoire étant relié à un ensemble respectif de lignes de mot ;
- le circuit électronique comprend plusieurs ensembles distincts de cellules mémoire propres à fonctionner en parallèle avec un même ensemble de lignes de mot et des ensembles distincts de paires de lignes de bit complémentaires, chaque ensemble de cellules mémoire étant relié à un ensemble respectif de paires de lignes de bit complémentaires ;

les dispositifs de lecture de deux ensembles de cellules mémoire successifs étant de préférence connectés entre eux via un interrupteur,

l'interrupteur étant de préférence encore commandé en position fermée lors d'une opération de calcul neuronal pour effectuer ladite opération avec l'ensemble des tensions d'entrée complémentaires reçues par les deux ensembles de cellules mémoire.

Ces caractéristiques et avantages de l'invention apparaîtront plus clairement à la lecture de la description qui va suivre, donnée uniquement à titre d'exemple non limitatif, et faite en référence aux dessins annexés, sur lesquels :

- la figure 1 est une représentation schématique d'un circuit électronique, selon l'invention, propre à mettre en œuvre des opérations de calcul fournissant chacune une sortie binaire, le circuit comprenant des lignes de mot, des paires de lignes de bit complémentaires, des lignes de source, un ensemble de cellules mémoire organisées selon une matrice comportant des rangées et des colonnes, chaque cellule mémoire comportant deux memristors et deux commutateurs, et un dispositif de lecture mis en œuvre lors de chaque opération de calcul ;
- la figure 2 est une représentation schématique d'un exemple de cellule mémoire du circuit électronique de la figure 1 ;
- la figure 3 est un graphe montrant l'effet de la variabilité des valeurs des résistances des états d'un memristor ;
- la figure 4 est une représentation schématique d'un exemple de réalisation d'un composant réalisant une opération XNOR et faisant partie du dispositif de lecture du circuit électronique de la figure 1 ;
- la figure 5 illustre les quatre cas possibles de fonctionnement du composant XNOR de la figure 4 ;
- la figure 6 est une représentation schématique de la tension en sortie du composant XNOR de la figure 4 dans certains cas de la figure 5 ;
- la figure 7 est une représentation schématique plus fonctionnelle du circuit électronique de la figure 1, et en particulier du dispositif de lecture ;
- la figure 8 est une représentation schématique du dispositif de lecture de la figure 1 selon un premier exemple de réalisation ;
- la figure 9 est un chronogramme de décharge d'un pont de conversion et de génération d'un signal de conversion, dans le cas du circuit électronique de la figure 8 sans biais ;
- la figure 10 est un chronogramme analogue à celui de la figure 9, dans le cas du circuit électronique de la figure 8 avec biais ;
- la figure 11 est une représentation schématique analogue à celle de la figure 8 selon des deuxième et troisième exemples de réalisation ;
- la figure 12 est une représentation schématique analogue à celle de la figure 8 selon un quatrième exemple de réalisation;
- la figure 13 est une représentation schématique analogue à celle de la figure 8 selon un cinquième exemple de réalisation;
- la figure 14 est une représentation schématique analogue à celle de la figure 8 selon des sixième et septième exemples de réalisation;
- la figure 15 est une représentation schématique analogue à celle de la figure 8 selon un huitième exemple de réalisation ;
- la figure 16 est une représentation schématique d'un circuit électronique selon l'invention comprenant plusieurs ensembles distincts de cellules mémoires connectés en série les uns des autres et à un même ensemble de lignes de mots, ces ensembles de cellules mémoire étant propres à fonctionner en parallèle en étant pilotés par des ensembles distincts de paires de lignes de bit complémentaires ;
- la figure 17 est une représentation schématique d'un circuit électronique selon l'invention comprenant une matrice d'ensembles distincts de cellules mémoires, les ensembles de cellules mémoire étant connectés les uns aux autres sous forme de rangées et de colonnes, les ensembles d'une même rangée étant connectés à un même ensemble de lignes de mot, et les ensembles d'une même colonne étant connectés à un même ensemble de paires de lignes de bit complémentaires ; et
- la figure 18 est une vue analogue à celle de la figure 17 selon un autre exemple de réalisation.

Il est à noter que l'expression « propre à » suivie d'un verbe est considérée équivalente à l'expression « configuré pour » suivie du même verbe. L'expression « propre à » sera alors au besoin remplaçable par l'expression « configuré pour », sans que cela ne modifie le contenu et la teneur de la présente invention.

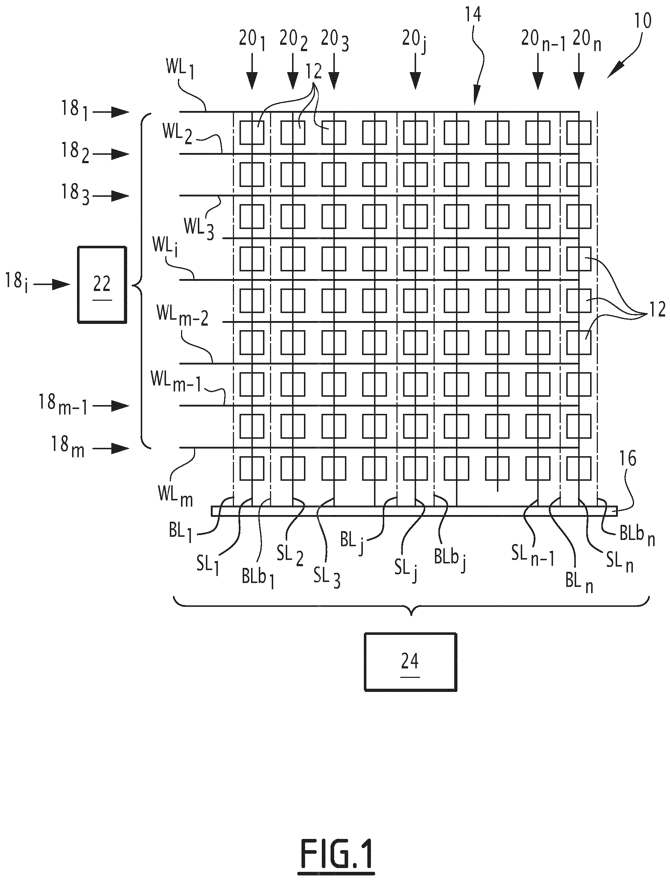

Sur la figure 1, un circuit électronique 10 est propre à prendre en entrée un vecteur x comprenant n entrées $x_j$ et à mettre en œuvre des opérations de calcul fournissant chacune une sortie binaire. Les opérations de calcul effectuées par le circuit électronique 10 sont par exemple des opérations de calcul neuronal, telles que des opérations de comptage du nombre de 1 dans une série de bits (de l'anglais *popcount*), voire des opérations MAC (de l'anglais *Multiply And Accumulate*) bien connues pour l'inférence des réseaux de neurones.

Le circuit électronique 10 est un circuit neuromorphique propre à mettre en œuvre un réseau de neurones à sortie binaire, c'est-à-dire un réseau pour lequel les poids synaptiques et les neurones sont binaires.

Le circuit électronique 10 comprend un ensemble de cellules mémoires 12 organisées selon une matrice 14 bidimensionnelle, configuré pour stocker les valeurs des poids synaptiques de chaque neurone et un dispositif de lecture 16 mis en œuvre lors de chaque opération de calcul.

Sur la figure 1, la matrice 14 comprend m rangées 18 et n colonnes 20, où m est le nombre de rangées 18 de la matrice 14, et similairement n est le nombre de colonnes 20 de la matrice 14, m et n étant chacun un entier supérieur ou égal à 1.

Une cellule mémoire 12 a les coordonnées (i,j) lorsque ladite cellule mémoire 12 est positionnée au croisement de la i-ième rangée 18i et de la j-ième colonne 20j avec i et j deux entiers. L'indice i est alors compris entre 1 et m, et l'indice j est compris entre 1 et n.

Les cellules mémoires 12 de la i-ième rangée 18 stocke les poids synaptiques d'un neurone. Le nombre de rangées 18 est donc fonction du nombre de neurones du réseau de neurones implémenté par le circuit électronique 10.

Le circuit électronique 10 comprend également des lignes de mot WL, des paires de lignes de bit complémentaires BL et BLb, des lignes de source SL et deux contrôleurs 22 et 24.

Dans les notations précédentes, une ligne de mot est référencée WL (de l'anglais *Word Line*) ; les lignes de bit complémentaires BL et BLb utilisent le sigle BL (de l'anglais *Bit Line*) et les lignes de source sont référencées avec le sigle SL (de l'anglais *Source Line*).

Dans l'exemple de la figure 1, chaque cellule mémoire 12 est connectée à une ligne de mot WL respective, une ligne de source SL respective et une paire respective de lignes de bit complémentaires BL et BLb.

Chaque cellule mémoire 12 d'une même rangée 18 partage la même ligne de mot WL, de sorte que les lignes de mot WL peuvent également être indexées avec l'indice i. Ainsi, la première ligne de mot, c'est-à-dire celle qui relie les cellules mémoires 12 de la première rangée 18, pourra être référencée $WL_1$.

Les cellules mémoire 12 d'une même colonne 20 partagent la même paire de lignes de bit complémentaires BL et BLb et la même ligne de source SL. Ces trois lignes peuvent donc également être indexées avec l'indice j.

Dans un souci de clarté, l'ensemble des lignes de source SL sont représentées mais seules les paires de lignes de bit complémentaires BL et BLb de la première colonne $20_1$, de la j-ième colonne $20_j$ et de la dernière colonne $20_n$ sont représentées en traits mixtes sur la figure 1.

Les cellules mémoire 12 d'une même rangée 18 sont alors sélectionnables par une ligne de mot WL, et les cellules mémoire 12 d'une même colonne 20 sont reliées à une paire de lignes de bit complémentaires BL, BLb et une ligne de source SL.

Le premier contrôleur 22 permet de sélectionner les cellules mémoire 12 d'une rangée 18 qui sont reliées à une même ligne de mot WL et donc de sélectionner un seul neurone parmi le circuit électronique 10.

Le deuxième contrôleur 24 est propre à contrôler les paires de lignes de bit complémentaires BL et BLb et les lignes de source SL.

Le deuxième contrôleur 24 est relié aux paires de lignes de bit BL, BLb et permet d'appliquer sur chaque paire de ligne de bit BL, BLb des tensions différentes, les tensions appliquées lors de l'opération de calcul étant avantageusement symétriques par rapport à une tension milieu, la tension appliquée sur une ligne de bit BL étant supérieure ou inférieure à celle appliquée sur la ligne de bit complémentaire BLb associée.

Le premier contrôleur 22 et le deuxième contrôleur 24 sont configurés pour être pilotés de manière coordonnée pour commander les cellules mémoires 12 à l'aide des lignes qu'ils contrôlent selon le fonctionnement souhaité.

Chaque cellule mémoire 12 est propre à mémoriser au moins une valeur binaire, telle qu'un poids binaire W, en particulier un poids synaptique binaire respectif du réseau de neurones lorsque l'opération de calcul effectuée est une opération de calcul neuronal.

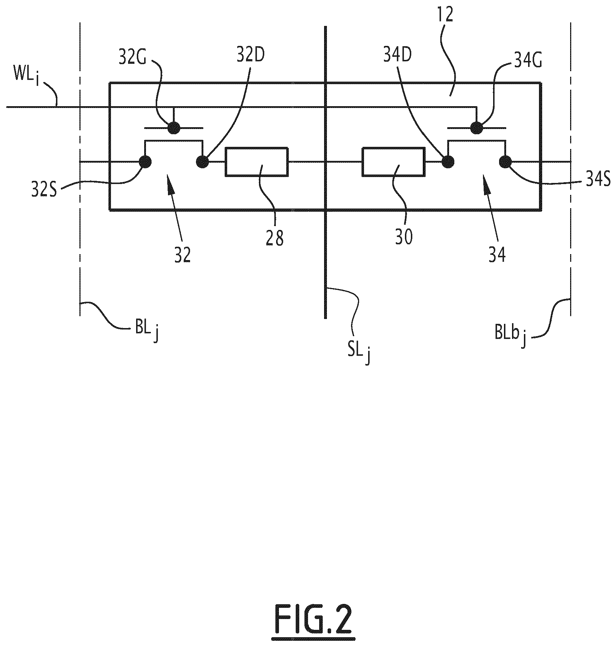

Un exemple de structure d'une cellule mémoire 12 est représentée plus précisément sur la figure 2 pour le cas de la cellule mémoire 12 ayant les coordonnées (i,j).

Chaque cellule mémoire 12 comporte deux memristors, à savoir un premier memristor 28 et un deuxième memristor 30, ainsi que deux commutateurs, un premier commutateur 32 et un deuxième commutateur 34.

Du fait que des memristors 28 et 30 sont présents, une telle cellule mémoire 12 est une cellule de mémoire résistive à accès aléatoire. La cellule mémoire 12 est plus souvent désigné par l'acronyme RRAM ou ReRAM (de l'anglais *Resistive random-access memory*).

En outre, un tel agencement est généralement appelé structure 2T2R en référence à la présence des deux commutateurs (appellation 2T) et de deux memristors (appellation 2R). La cellule mémoire 12 est parfois dénommée cellule 2T2R.

Un memristor est un composant dont la valeur de sa résistance électrique change, de façon permanente, lorsqu'un courant est appliqué. Ainsi, une donnée peut être enregistrée et réécrite par un courant de contrôle. Un tel comportement est notamment observé dans les matériaux à changement de phase, les jonctions tunnel ferroélectriques ou les mémoires redox à base d'oxydes tels que le $HfO_x$ ou $TiO_{2-x}$.

Le changement de conductance d'un memristor dépend de l'amplitude et de la durée des impulsions de tension appliquées à travers le memristor ainsi que de la valeur maximale de courant pouvant passer dans le memristor par exemple pour une opération de « SET », c'est-à-dire le passage d'une résistance forte à une résistance faible.

Un memristor peut ainsi présenter deux états, un état haut et un état bas.

L'état haut correspond à une forte résistance et est généralement désigné par l'abréviation HRS renvoyant au terme anglais de « *High Resistive State* » qui signifie littéralement état fortement résistif. L'état haut est, de ce fait, dénommé état haut HRS dans la suite.

L'état bas correspond à une faible résistance et est généralement désigné par l'abréviation LRS renvoyant au terme anglais de « *Low Resistive State* » qui signifie littéralement état faiblement résistif. L'état bas est, de ce fait, dénommé état bas LRS dans la suite.

Toutefois, du fait de la variabilité des memristors en fonctionnement, il se trouve que la résistance dans l'état haut HRS peut être inférieure à la résistance dans l'état bas LRS, ce qui génère des erreurs si l'information (poids) est codée dans un seul memristor.

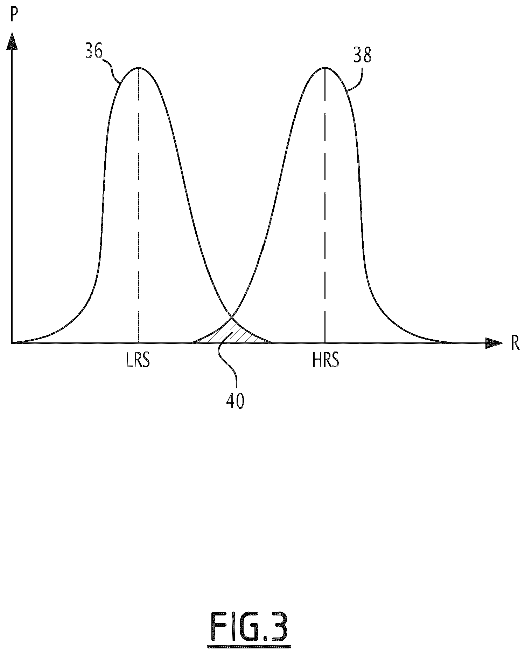

Cette variabilité est présentée schématiquement sur la figure 3. Dans cette figure, il est représenté la probabilité qu'un memristor présente en pratique la valeur de résistance en fonction de l'état du memristor.

Plus précisément, la première courbe, la courbe notée 36, représente schématiquement la probabilité pour l'ensemble des valeurs observées en pratique pour l'état bas LRS tandis que la deuxième courbe 38 représente la même courbe pour l'état haut HRS.

Le graphe de la figure 3 montre bien qu'il existe une zone de recouvrement 40. Dans cette zone de recouvrement 40, distinguer les états bas LRS et haut HRS peut être impossible.

Ce recouvrement peut être plus important avec les dérives temporelles à long terme des memristors.

Pour remédier à ce problème, dans le présent exemple, l'information est codée par le rapport entre les deux résistances des deux états grâce à une configuration en différentiel des deux memristors 28 et 30.

Aussi, selon l'exemple décrit, les memristors 28 et 30 sont des memristors en série et complémentaires respectant le même codage logique.

Par complémentaire, il est ici entendu que les memristors 28 et 30 présentent un état différent, un état bas LRS pour l'un et un état haut HRS pour l'autre.

Selon l'exemple de la figure 2, un poids fort, c'est-à-dire un « 1 » logique, est représenté par un état haut HRS du premier memristor 28 (respectivement un état bas LRS du deuxième memristors 30) tandis qu'un poids faible, c'est-à-dire un « 0 » logique, est représenté par un état bas LRS du premier memristor 28 (respectivement un état haut HRS du deuxième memristors 30).

Dans l'exemple décrit, chacun des deux memristors 28 et 30 est relié à la ligne de source SL commune.

Chacun des deux commutateurs 32 et 34 est par exemple un transistor et plus spécifiquement un transistor à effet de champ.

Un transistor à effet de champ est souvent désigné par l'abréviation FET (de l'anglais *Field-Effect Transistor)*.

Selon l'exemple décrit, les deux commutateurs 32 et 34 sont des transistors à effet de champ à grille isolée. Un tel transistor est plus souvent désigné sous l'acronyme MOSFET (de l'anglais *Metal Oxide Semiconductor Field Effect Transistor*).

Ainsi, chaque commutateur 32 et 34 présente trois électrodes, une grille G, une source S et un drain D.

De manière générale, pour un transistor dont le signe de référence est X, les électrodes seront notées sur les figures selon la notation suivante : la grille XG, la source XS et le drain XD.

Cette notation est choisie ici pour simplifier la représentation, sachant que les positions de la source XS et du drain XD sont définies par rapport au sens de polarisation principal, c'est-à-dire le plus usité pour le montage. Bien entendu, si la polarisation est inversée, l'homme du métier sait que les rôles et les positions de la source XS et du drain XD sont échangés.

Chaque grille 32G et 34G des deux commutateurs 32 et 34 est connectée à la ligne de mot WL. Selon le niveau de tension présent sur la ligne de mot, les commutateurs 32 et 34 sont rendus passants ou au contraire non passants. Le premier contrôleur 22 va en pratique choisir de sélectionner une rangée 18 de cellules 12 par une ligne de mot WL en rendant conducteurs les commutateurs 32, 34 des cellules mémoires 12 de cette rangée.

La source 32S du premier commutateur 32 est reliée à la ligne de bit BL tandis que la source 34S du deuxième commutateur 34 est reliée à la ligne de bit complémentaire BLb.

Le drain 32D du premier commutateur 32 est relié à une borne du premier memristor 28, l'autre borne du premier memristor 28 étant reliée à la ligne de source SL commune.

Le drain 34D du deuxième commutateur 34 est relié à une borne du deuxième memristor 30, l'autre borne du deuxième memristor 30 étant reliée à la ligne de source SL commune.

Le deuxième contrôleur 24 va piloter l'alimentation des paires de lignes de bits, de sorte à ce que la tension présentée sur une ligne de bit $BL_j$ soit différente et complémentaire de la tension présentée sur la ligne de bits complémentaire $BL_j$. Ainsi, quand une cellule 12 de coordonnée i,j est sélectionnée (ses commutateurs étant rendus passant par la tension d'activation présentée sur la ligne de mot $WL_i$ associée), les memristors 28 et 30 de cette cellule sont en série et constituent un pont résistif entre les lignes de bit $BL_j$ et $BLb_j$.

Dans le cas d'espèce, les memristors 28 et 30 sont ainsi alimentés par des tensions présentes sur les lignes de bit $BL_j$ et $BLb_j$ symétriques par rapport à une tension par exemple $\frac{V_{DD}}{2}$, dite tension milieu. Dans cette notation, $V_{DD}$ correspond à un potentiel d'alimentation $V_{DD}$. En outre, la masse est notée GND dans la suite. Bien entendu, il pourrait être choisi une autre tension milieu comme, par exemple, une tension de $\frac{V_{DD}}{3}$.

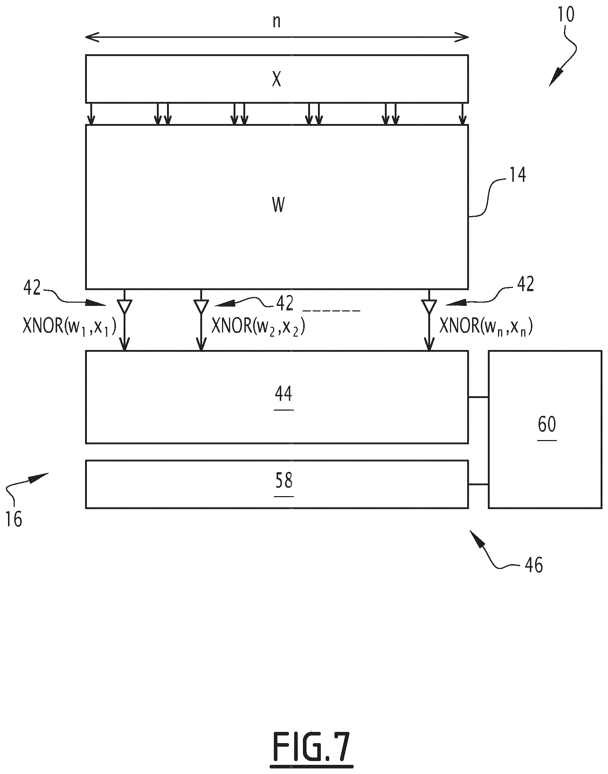

Le dispositif de lecture 16 mis en œuvre lors de chaque opération de calcul va maintenant être décrit en référence à la figure 7.

Pour bien comprendre ce qui va suivre, il peut être observé qu'un réseau de neurones binaire présente une spécificité dans l'inférence par rapport à un réseau de neurones classique.

Quand un réseau de neurones classique est appliqué sur un vecteur d'entrée pour calculer un vecteur de sortie, chaque neurone reçoit des valeurs d'entrée correspondant à des valeurs de sortie des neurones d'une couche précédente $x_j$ et réalise une somme pondérée $\sum_j W_{ij} \cdot x_j$ et le neurone applique ensuite une fonction non-linéaire $f$ au résultat de la somme pondérée.

Par contraste, dans un réseau de neurones binaire, la somme pondérée est obtenue en réalisant l'opération suivante :

$$a_i = sign[popcount_j\, XNOR(W_{ij}, x_j) - Th_i]$$

où $a_i$ et $x_j$ représentent les valeurs de sortie calculées par les neurones de la couche actuelle, respectivement par la couche précédente ;

$W_{ij}$ représente les poids binaires respectifs pour les neurones de la couche actuelle ;

*XNOR* est la fonction logique donnant le complément de la fonction OU exclusive (cette fonction est parfois dénommée NON-OU exclusif de ce fait) ;

*popcount* est la fonction qui compte le nombre de 1 dans une série de bits ;

$Th_i$ est un seuil prédéfini, et

*sign* est une fonction associant la valeur 1 à une entrée positive et associant - 1 à une valeur négative.

Cela signifie que, dans le cas d'un réseau binaire, il est possible de mettre un calcul neuronal binaire via le circuit électronique 10 comprenant le dispositif de lecture 16 comme représenté sur la figure 7.

Le dispositif de lecture 16 comprend une unité logique 42 pour chaque colonne 20, un module de conversion 44 et un module de comparaison 46.

Chaque unité logique 42 forme en combinaison avec une cellule mémoire 12 sélectionnée dans la colonne 20 associée à ladite unité logique 42, un composant équivalent XNOR 43.

L'unité logique 42 comprend une borne d'entrée connectée à la ligne source SL de ladite cellule mémoire 12 pour recevoir une valeur d'entrée.

Chaque unité logique 42 est configurée pour effectuer une opération logique présentant un basculement entre une valeur basse et une valeur haute en fonction uniquement la valeur de l'entrée de l'unité logique qui est connectée à la ligne de source SL lors de ladite opération de calcul.

Plus particulièrement, un « 1 » logique est représenté par une valeur haute en sortie de l'unité logique 42 et un « 0 » logique est représenté par une valeur basse en sortie de l'unité logique 42.

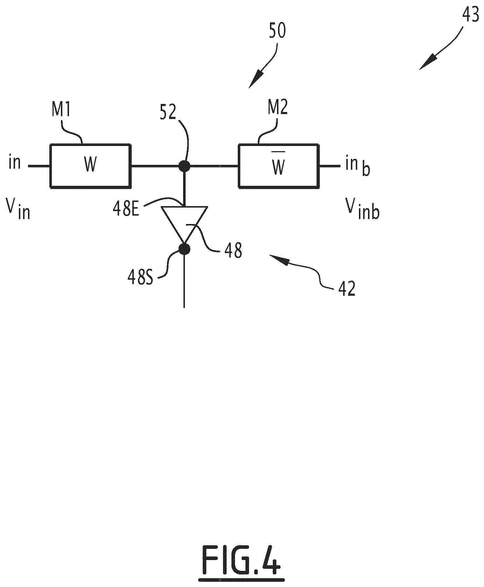

Le composant XNOR 43 équivalent à l'association entre la cellule mémoire 12 sélectionnée et l'unité logique 42 est décrit maintenant en référence à la figure 4.

Le composant XNOR 43 réalise une opération XNOR sur deux signaux, à savoir un poids noté W et un signal d'entrée noté in.

En l'espèce, le composant XNOR 43 comporte deux memristors M1 et M2 et une unité logique 42.

Dans l'exemple de la figure 4, l'unité logique 42 est un inverseur 48.

Les deux memristors M1 et M2 sont des memristors complémentaires connectés en série correspondant au poids W.

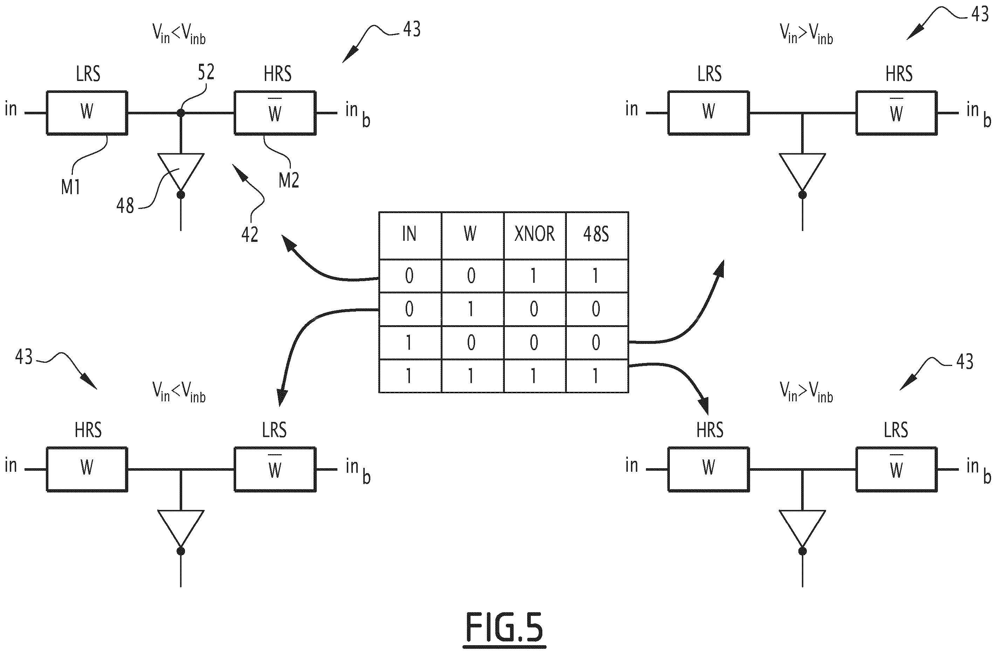

Aussi, similairement à ce qui a été décrit précédemment, selon l'exemple de la figure 5, un « 1 » logique pour le poids W est représenté par un état haut HRS du memristor M1 (l'autre memristor M2 étant dans l'état bas LRS) tandis qu'un « 0 » logique pour le poids W est représenté par un état bas LRS du memristor M1 (l'autre memristor M2 étant dans l'état haut HRS).

Les memristors M1 et M2 sont reliés à une extrémité à l'inverseur 48 et à l'autre extrémité à une tension respective.

On notera une première tension $V_{in}$ et une deuxième tension $V_{inb}$.

La configuration électrique est donc celle d'un pont diviseur de tension 50 relié d'une part à la première tension $V_{in}$ et d'autre part à la deuxième tension $V_{inb}$ et dont le point milieu 52 est relié à l'entrée de l'inverseur 48. Autrement formulé, l'un des memristors M1 est soumis à une tension $|V_{in} - V_{mid}|$ et l'autre memristor M2 est soumis à une tension $|V_{mid} - V_{inb}|$. La notation $V_{mid}$ désigne la tension du point milieu 52 du pont diviseur 50.

Ainsi, dans le cas décrit, le signal d'entrée in correspond à la paire de la première tension $V_{in}$ et de la deuxième tension $V_{inb}$.

Ces tensions $V_{in}$ et $V_{inb}$ ont par exemple la particularité d'être symétriques par rapport à la moitié du potentiel d'alimentation $\frac{V_{DD}}{2}$. En pratique, on pourra avantageusement choisir d'avoir $V_{in}$ égale à $V_{DD}$ ou GND, et respectivement $V_{inb}$ égale à GND ou $V_{DD}$.

Dans l'exemple de la figure 5, le signal d'entrée in code pour un « 1 » logique lorsque la première tension $V_{in}$ est strictement supérieure à la deuxième tension $V_{inb}$, c'est-à-dire que $V_{in} > V_{inb}$. Réciproquement, le signal d'entrée in code un « 0 » logique lorsque la première tension $V_{in}$ est strictement inférieure à la deuxième tension $V_{inb}$, c'est-à-dire que $V_{in} < V_{inb}$.

Cette représentation schématique de deux memristors M1, M2 en série entre deux tensions $V_{in}$ et $V_{inb}$ correspond en pratique au circuit équivalent formé par une cellule 12 sélectionnée (la ligne de mot WL associée présente une tension rendant ses commutateurs passants) et recevant via les lignes de bit BL et BLb des tensions de polarisation correspondant à $V_{in}$ et $V_{inb}$. Autrement dit, le signal d'entrée in est amené à une cellule 12 sélectionnée via les lignes de bit BL et BLb associées par l'action du deuxième contrôleur 24. Le point milieu 52 du pont diviseur correspond alors à la ligne de source SL connectée à la cellule 12 considérée.

L'inverseur 48 est un élément propre à recevoir un signal incident sur une entrée 48E et effectuer un calcul d'inversion logique pour émettre sur une sortie 48S un signal de sortie qui est l'inverse du signal incident.

Ici, l'entrée 48E de l'inverseur 48 est connectée au point milieu 52 du pont diviseur 50 formé par les deux memristors M1 et M2.

La sortie 48S de l'inverseur 48 donne le résultat de l'opération XNOR appliquée au signal d'entrée in et au poids W.

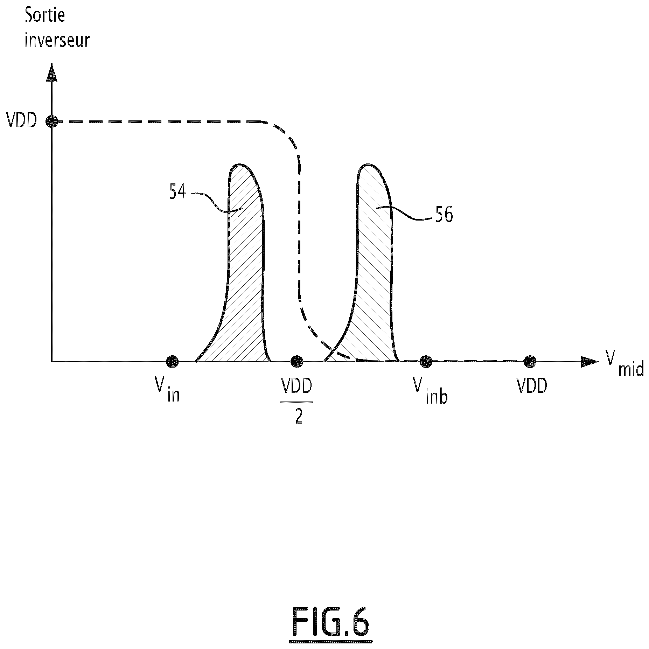

Le fonctionnement du composant équivalent XNOR 43 est maintenant décrit en référence aux figures 5 et 6 qui représentent schématiquement respectivement les quatre cas possibles de fonctionnement du composant XNOR 43 et la valeur des tensions en sortie pour deux des quatre cas possibles. Dans la figure 5, les signes de référence ne sont pas repris pour ne pas trop alourdir ces figures.

Plus précisément, le cas en haut à gauche de la figure 5 correspond au cas où le signal d'entrée in vaut 0 et la valeur du poids W est égale à 0.

Dans un tel cas, comme expliqué précédemment, la première tension $V_{in}$ est strictement inférieure à la deuxième tension $V_{inb}$, c'est-à-dire que $V_{in} < V_{inb}$ (avec par exemple $V_{in}$ = GND et $V_{inb} = V_{DD}$).

En outre, le premier memristor M1 est dans l'état bas LRS alors que le deuxième memristor M2 est dans l'état haut HRS.

Du fait de la configuration, le memristor dans l'état haut HRS absorbe la quasi-totalité de la dynamique de tension, repoussant la tension $V_{mid}$ du point milieu 52 vers la tension à l'extrémité du memristor dans l'état bas LRS

En l'occurrence, cela signifie que la tension $V_{mid}$ du point milieu 52 est repoussée vers la première tension $V_{in}$ comme représenté schématiquement par la courbe 54 sur la figure 6.

Comme apparent sur cette figure 6, la tension du point milieu $V_{mid}$ est distinctement au-dessous de la moitié du potentiel d'alimentation $V_{DD}/2$.

La sortie 48S de l'inverseur 48 est alors à 1.

Cela montre que pour un signal in à 0 et pour un poids à 0, la sortie de l'inverseur 48 est alors à 1, ce qui correspond bien à XNOR(0,0) = 1.

Ainsi, la sortie de l'unité logique 42 est donc un « 1 » logique, donc la sortie de l'unité logique 42 est une valeur haute.

Le cas en bas à gauche de la figure 5 correspond au cas correspondant dans lequel le signal d'entrée in vaut 0 et la valeur du poids W est égal à 1.

Dans un tel cas, par rapport au cas précédent, la seule différence est que le premier memristor M1 est dans l'état haut HRS alors que le deuxième memristor M2 est dans l'état bas LRS.

Il en résulte que la tension du point milieu $V_{mid}$ est repoussée vers la deuxième tension $V_{inb}$ comme représenté schématiquement par la courbe 56 sur la figure 6.

La sortie 48S de l'inverseur 48 est alors à 0.

Cela montre que pour un signal in à 0 et pour un poids W à 1, la sortie de l'inverseur 48 est alors à 0, ce qui correspond bien à XNOR(0,1) = 0.

Ainsi, la sortie de l'unité logique 42 est donc un « 0 » logique, donc la sortie de l'unité logique 42 est une valeur basse.

Les mêmes remarques s'appliquent pour les cas à droite sur la figure 5.

Le cas du haut correspond un signal d'entrée in valant 1 ($V_{in} > V_{inb}$, avec par exemple $V_{in} = V_{DD}$ et $V_{inb} = GND$) et un poids W valant 0 (premier memristor M1 dans l'état bas LRS et deuxième memristor M2 dans l'état haut HRS) de sorte que la tension du point milieu $V_{mid}$ est repoussée vers la première tension $V_{in}$, c'est-à-dire que $V_{mid} > \frac{V_{DD}}{2}$. Il en résulte que la sortie 48S de l'inverseur 48 et donc de l'unité logique 42 est un « 0 » logique. Cela correspond bien à réaliser l'opération XNOR(1,0) = 0.

Le cas du bas correspond à un signal d'entrée in valant 1 ($V_{in} > V_{inb}$) et un poids valant 1 (premier memristor M1 dans l'état haut HRS et deuxième memristor M2 dans l'état bas LRS) de sorte que la tension du point milieu $V_{mid}$ est repoussée vers la deuxième tension $V_{inb}$, c'est-à-dire que $V_{mid} < \frac{V_{DD}}{2}$. Il en résulte que la sortie 48S de l'inverseur 48 et donc de l'unité logique est un « 1 » logique. Cela correspond bien à réaliser l'opération XNOR(1,1) = 1.

Les différents cas décrits conduisent à obtenir la table de vérité visible sur la figure 5, qui illustre bien que la sortie 48S de l'inverseur réalise une opération XNOR.

Un tel composant XNOR 43 permet d'obtenir une sortie en tension qui ne présente pas la variabilité de résistance des memristors M1 et M2.

La réduction de la variabilité provient de deux facteurs complémentaires.

Une première réduction de la variabilité est obtenue par utilisation du montage en différentiel des deux memristors M1 et M2. Néanmoins, au niveau du point milieu 52 du pont diviseur 50, le signal est encore sujet aux variabilités des memristors M1 et M2. De fait, la tension du point milieu dépend du ratio entre les valeurs des résistances des memristors M1 et M2, ce qui diminue la variabilité, mais pas complètement.

La deuxième réduction de variabilité est obtenue avec l'emploi de l'unité logique 42 comme cela apparaît en référence à la figure 6.

Il en résulte que le signal en sortie de l'unité logique 42 est beaucoup moins sensible aux variations de résistance des memristors M1, M2. C'est seulement dans les pires cas où les distributions statistiques de valeurs de résistances se chevauchent qu'il pourra y avoir d'éventuelles erreurs résiduelles. En pratique, il est néanmoins possible d'éviter ce chevauchement en appliquant des tensions et courant de programmation suffisants.

Le module de conversion 44 est configuré pour convertir un nombre de valeurs hautes ou basses en sortie des unités logiques 42 en une grandeur intermédiaire dépendant dudit nombre de valeurs hautes ou basses en sortie des unités logiques 42.

Pour rappel, une valeur haute correspond à un « 1 » logique et une valeur basse correspond à un « 0 » logique.

Par « intermédiaire » dans « grandeur intermédiaire », on entend intermédiaire dans la succession d'actions nécessaires pour effectuer l'opération de calcul, depuis la réception de chaque valeur d'entrée en bas de colonne jusqu'à l'émission du signal représentatif du résultat de l'opération de calcul.

Autrement dit, la grandeur intermédiaire est représentative du nombre de « 1 » et de « 0 » logiques en sortie des unités logiques 42 de chaque colonne 20.

En particulier, la grandeur intermédiaire est représentative du résultat de l'opération *popcount XNOR($W_j, x_i$)*.

La grandeur intermédiaire est par exemple une grandeur électrique, telle qu'une tension électrique, dont la variation au cours du temps dépend d'une constante de temps, et la valeur de la constante de temps est fonction du nombre de valeurs hautes ou basses en sortie des unités logiques 42.

La constante de temps est alors directement proportionnelle au nombre de valeurs hautes ou basses en sortie des unités logiques 42. Par exemple la constante de temps est proportionnelle au résultat de l'opération *popcount XNOR* ($W_j, x_j$).

De préférence, la valeur de la constante de temps est égale au produit d'une capacité et d'une résistance, et est alors notée RC, l'une parmi la capacité et la résistance étant prédéfinie, et l'autre parmi la capacité et la résistance dépendant du nombre de valeurs hautes ou basses en sortie des unités logiques 42.

Le module de comparaison 46 est configuré pour comparer la grandeur intermédiaire à une grandeur de référence et pour émettre en sortie un signal numérique sur un bit, dépendant de la comparaison et correspondant à la sortie du circuit électronique 10, le signal émis étant représentatif du résultat de l'opération de calcul.

En référence à la figure 7, le module de comparaison 44 comprend une unité 58 d'obtention de la grandeur de référence et une unité de comparaison 60.

L'unité d'obtention 58 est configurée pour fournir en sortie une grandeur de référence comparable à la grandeur intermédiaire.

Par exemple, si la grandeur intermédiaire est une tension électrique, l'unité d'obtention 58 est configurée pour fournir en sortie une tension électrique.

L'unité de comparaison 60 est reliée au module de conversion 44 et à l'unité d'obtention 58.

L'unité de comparaison 60 prend en entrée la grandeur de référence fournie par l'unité d'obtention 58 et la grandeur intermédiaire fournie par le module de conversion 44, et émet en sortie un signal sur un bit, correspondant au résultat de la comparaison de la grandeur intermédiaire et de la grandeur de référence.

Le signal émis est représentatif d'un « 1 » logique ou d'un « 0 » logique en fonction de la comparaison entre les deux grandeurs précédentes et donc du résultat de l'opération.

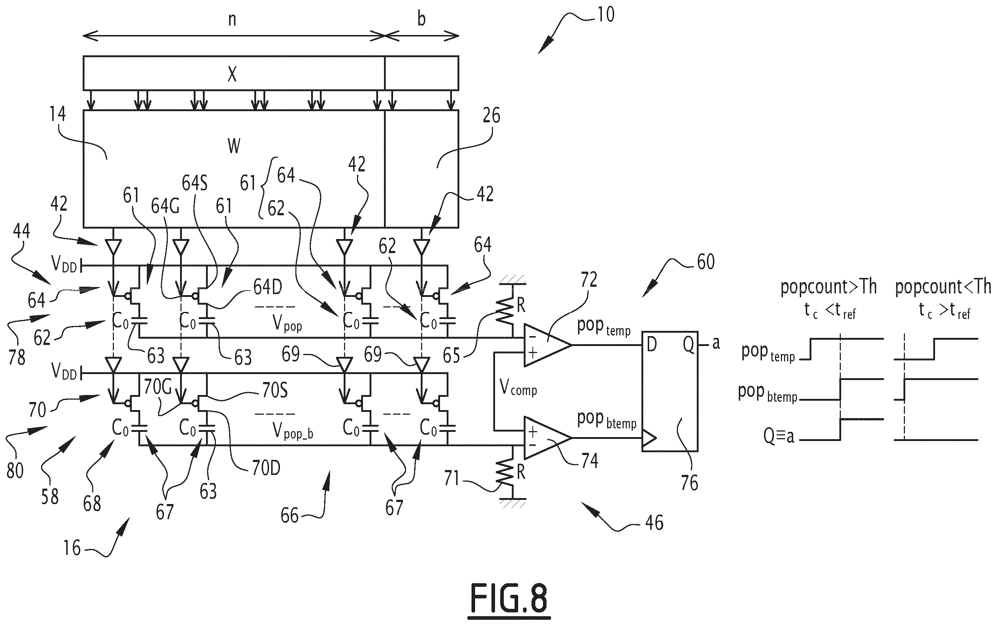

Un premier exemple de réalisation du dispositif de lecture 16 du circuit électronique 10 selon l'invention va maintenant être décrit en référence aux figures 8 à 10.

Le circuit électronique 10 comprend la matrice 14 de cellules mémoire 12 avec m rangées 18 et n colonnes 20.

En complément facultatif, le circuit électronique 10 comprend une matrice supplémentaire 26 de cellules mémoires 12, également appelée matrice de biais 26, décrite plus en détail par la suite.

Le module de conversion 44 comprend un ensemble de mêmes premiers éléments 62 reliés entre eux et un ensemble de premiers commutateurs 64, chaque premier élément 62 étant associé à la sortie d'une unité logique 42 respective, comme représenté sur la figure 8.

Le nombre de premiers éléments 62 et le nombre de premiers commutateurs 64 sont égaux, chacun étant égal au nombre n de colonnes 20, et donc au nombre d'unités logiques 42.

Chaque premier commutateur 64 est connecté en sortie d'une unité logique 42 respective et est configuré pour activer, ou respectivement inhiber, le premier élément 62 correspondant selon la valeur, haute ou basse, en sortie de l'unité logique 42 respective. La valeur de la constante de temps dépend alors du nombre de premier(s) élément(s) 62 activé(s).

Dans l'exemple de la figure 8, si un « 0 » logique est calculé en sortie d'une unité logique 42 respective, le premier commutateur 64 respectif est configuré pour activer le premier élément 62 correspondant ; et corollairement si un « 1 » logique est calculé en sortie d'une unité logique 42 respective, le premier commutateur 64 respectif est configuré pour inhiber le premier élément 62 correspondant. Cet exemple de logique de commande du premier élément 62 correspond au cas où chaque premier commutateur 64 comporte un transistor PMOS. L'homme du métier comprendra bien entendu que la logique de commande précitée est inversée si chaque premier commutateur 64 comporte un transistor NMOS, le premier commutateur 64 respectif étant alors configuré pour activer le premier élément 62 correspondant si un « 1 » logique est calculé en sortie d'une unité logique 42, et corollairement pour inhiber le premier élément 62 correspondant si un « 0 » logique est calculé en sortie de l'unité logique 42. Le nombre de premier(s) élément(s) 62 activé(s) est alors égal à $n - popcount\ XNOR(W_j, x_j)$.

Le premier élément 62 et le premier commutateur 64 correspondant forment une unité de conversion 61 connectée en sortie de l'unité logique 42.

Dans l'exemple de la figure 8, chaque premier élément 62 comprend un condensateur 63, chaque premier élément 62 étant de préférence constitué du condensateur 63. Les condensateurs 63 ont avantageusement tous la même capacité de valeur $C_0$.

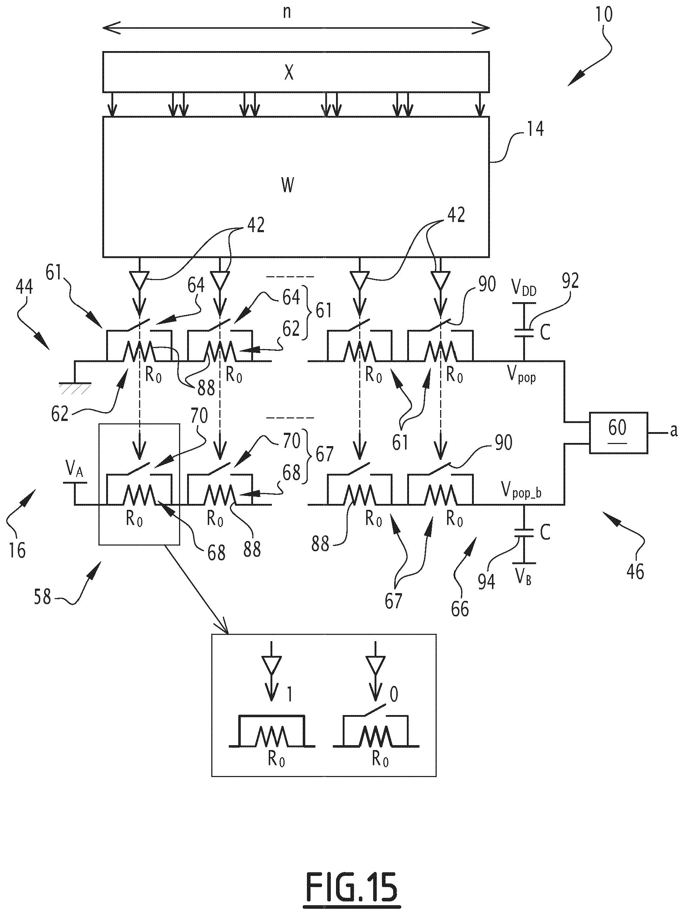

En variante, comme cela sera décrit plus en détail dans l'exemple de la figure 15, chaque premier élément 62 comprend une résistance, chaque premier élément 62 étant de préférence une résistance.

Chaque premier commutateur 64 comprend par exemple un transistor, tel qu'un transistor à effet de champ. Chaque grille 64G du transistor d'un premier commutateur 64 respectif est connectée à la sortie de chaque unité logique 42. La source 64S dudit transistor est reliée à une ligne de tension de valeur prédéfinie, telle que la valeur $V_{DD}$, et le drain 64D dudit transistor est connecté à un condensateur 63 respectif.

Tous les premiers éléments 62 sont agencés les uns à la suite des autres sous forme d'un pont de conversion 78, également appelé pont pop.

Les unités de conversion 61 sont donc agencées les unes à la suite des autres pour former le pont de conversion 78. Lorsque chaque premier élément 62 comprend un condensateur 63 respectif, les unités de conversion 61 sont connectées en parallèle les unes des autres, entre une première ligne à une première tension prédéfinie, telle que la tension $V_{DD}$, et une première ligne complémentaire à une autre tension, dite tension pop et notée $V_{pop}$, correspondant à la grandeur intermédiaire en sortie du module de conversion 44.

Pour le pont de conversion 78, le nombre de condensateur(s) 63 connecté(s) en parallèle est alors égal au nombre de premier(s) élément(s) 62 activé(s), c'est-à-dire à $n - popcount\ XNOR(W_j, x_j)$. L'ensemble des condensateurs 63 du pont de conversion 78 est donc équivalent à un unique condensateur de capacité $(n - popcount\ XNOR(W_j, x_j)) * C_0$ connecté entre les tensions $V_{DD}$ et $V_{pop}$.

Le module de conversion 44 comprend en outre une première résistance 65 d'impédance prédéfinie R, connectée entre la première ligne complémentaire à la tension $V_{pop}$ et un potentiel prédéfini, telle qu'une masse électrique GND. La première résistance 65 est incluse dans le pont de conversion 78.

Ainsi, si le pont de conversion 78 est initialement préchargé à la première tension prédéfinie $V_{DD}$, la mise en oeuvre d'une opération de calcul, c'est-à-dire l'activation d'une rangée 18 par sa ligne de mot WL et l'application des activations d'entrée sur les lignes de bit complémentaires $BL/BL_B$, générera la décharge d'un condensateur équivalent de capacité $(n - popcount\ XNOR(W_j, x_j)) * C_0$ à travers la première résistance 65.

La grandeur intermédiaire étant la tension $V_{pop}$ de la première ligne complémentaire connectée à la fois aux condensateurs 63 de capacité $C_0$ et à la première résistance 65 d'impédance R, la variation au cours du temps de la grandeur intermédiaire dépend d'une constante de temps égale à $(n - popcount\ XNOR(W_j, x_j)) * RC_0$.

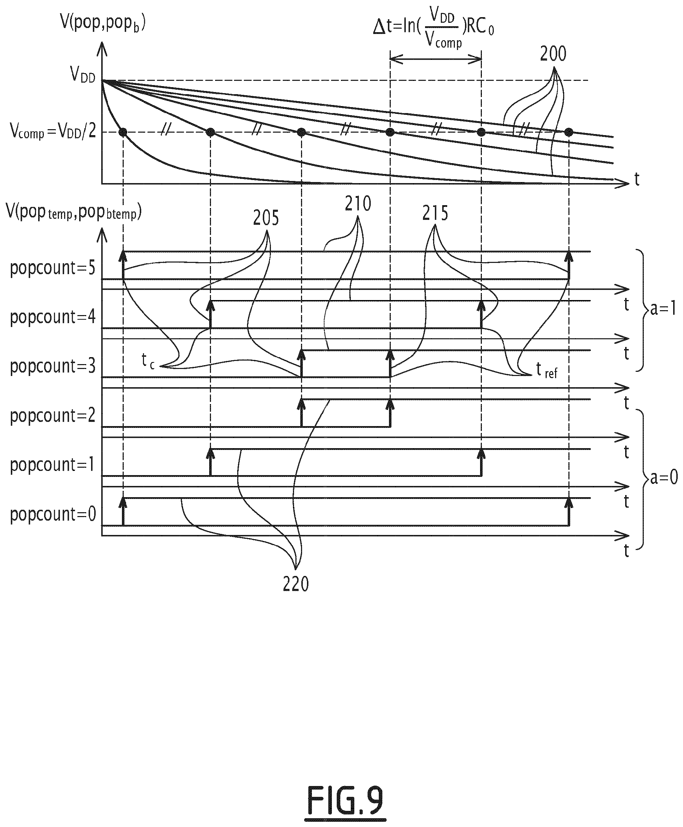

La variation au cours du temps de la tension $V_{pop}$ dans l'exemple de la figure 8 est représentée pour plusieurs valeurs de popcount et n=5 sur les courbes 200 en haut de la figure 9.

L'unité d'obtention 58 comprend par exemple un générateur 66 de tension de référence. Dans l'exemple de la figure 8, le générateur de tension de référence 66 est en forme d'un pont de génération 80, symétrique par rapport au pont de conversion 78 du module de conversion 44.

Le générateur de tension de référence 66 comprend alors un ensemble de mêmes deuxièmes éléments 68 reliés entre eux et un ensemble de deuxièmes commutateurs 70, les deuxièmes éléments 68 étant avantageusement identiques aux premiers éléments 62.

Chaque deuxième élément 68 est associé à la sortie d'une unité logique 42 respective, chaque deuxième commutateur 70 étant connecté en sortie d'une unité logique 42 respective et configuré pour activer, ou respectivement inhiber, le deuxième élément 68 correspondant selon la valeur haute ou basse en sortie de l'unité logique respective.

Chaque deuxième commutateur 70 est commandé de manière inversée par rapport au premier commutateur 64 du module de conversion 44 qui est connecté en sortie de la même unité logique 42 respective.

En particulier, si un « 1 » logique est calculé en sortie d'une unité logique 42, le deuxième commutateur 70 respectif est configuré pour activer le deuxième élément 68 correspondant ; et corollairement si un « 0 » logique est calculé en sortie d'une unité logique 42, le deuxième commutateur 70 respectif est configuré pour inhiber le deuxième élément 68 correspondant. Cet exemple de logique de commande du deuxième élément 68 correspond au cas où chaque deuxième commutateur 70 comporte un transistor NMOS. L'homme du métier comprendra bien entendu que la logique de commande précitée est inversée si chaque deuxième commutateur 70 comporte un transistor PMOS, le deuxième commutateur 70 respectif étant alors configuré pour activer le deuxième élément 68 correspondant si un « 0 » logique est calculé en sortie d'une unité logique 42, et corollairement pour inhiber le deuxième élément 68 correspondant si un « 1 » logique est calculé en sortie de l'unité logique 42. Le nombre de deuxième(s) élément(s) 68 activé(s) est alors égal au résultat du $popcount\ XNOR(W_j, x_j)$.

Le deuxième élément 68 et le deuxième commutateur 70 correspondant forment une unité de génération 67 connectée en sortie de l'unité logique 42.

A cet effet, dans l'exemple de la figure 8, chaque deuxième élément 68 comprend aussi un condensateur 63, chaque deuxième élément 68 étant de préférence un condensateur 63. Les condensateurs 63 ont avantageusement tous la même capacité de valeur $C_0$.

En variante, comme cela sera décrit plus en détail dans l'exemple de la figure 15, chaque deuxième élément 68 comprend une résistance, chaque deuxième élément 68 étant de préférence une résistance.

Chaque deuxième commutateur 70 comprend par exemple un inverseur 69 et un transistor, tel qu'un transistor à effet de champ. Le transistor du deuxième commutateur 70 est avantageusement de même type que celui du premier commutateur 64, c'est-à-dire présentant la même logique de commande.

La sortie de chaque unité logique 42 est alors connectée à un inverseur 69 respectif, lui-même connecté au transistor du deuxième commutateur 70 correspondant, ledit transistor étant alors connecté à un condensateur 63 respectif.

En variante, non représentée, chaque deuxième commutateur 70 comprend seulement un transistor, tel qu'un transistor à effet de champ, et ne comprend en particulier pas d'inverseur. Selon cette variante, le transistor du deuxième commutateur 70 présente une logique de commande inverse à celle du transistor du premier commutateur 64.

Chaque grille 70G du transistor d'un deuxième commutateur 70 respectif est connectée à la sortie de chaque unité logique 42. La source 70S dudit transistor est reliée à une ligne de tension de valeur prédéfinie, telle que la valeur $V_{DD}$, et le drain 70D dudit transistor est connecté à un condensateur 63 respectif.

Tous les deuxièmes éléments 68 sont agencés les uns à la suite des autres sous forme du pont de génération 80, également appelé pont $pop_b$.

Les unités de génération 67 sont donc agencées les unes à la suite des autres pour former le pont de génération 80. Lorsque chaque deuxième élément 68 comprend un condensateur 63 respectif, les unités de génération 67 sont connectées en parallèle les unes des autres, entre une deuxième ligne à une deuxième tension prédéfinie, telle que la tension $V_{DD}$, et une deuxième ligne complémentaire à une autre tension, dite tension pop_b et notée $V_{pop\_b}$, correspondant à la grandeur de référence.

Pour le pont de génération 80, le nombre de condensateur(s) 63 connecté(s) en parallèle est alors égal au nombre de deuxième(s) élément(s) 68 activé(s), c'est-à-dire à *popcount XNOR(Wⱼ, xᵢ)*. L'ensemble des condensateurs 63 du pont de génération 80 est donc équivalent à un unique condensateur de capacité *popcount XNOR(Wⱼ, xᵢ)* * $C_0$ connecté entre les tensions $V_{DD}$ et $V_{pop\_b}$.

Le générateur de tension de référence 66 comprend en outre une deuxième résistance 71, d'impédance prédéfinie et avantageusement identique à l'impédance R de la première résistance 65. La deuxième résistance 71 est connectée entre la deuxième ligne complémentaire à la tension $V_{pop\_b}$ et un potentiel prédéfini, telle que la masse électrique GND. La deuxième résistance 71 est incluse dans le pont de génération 80.

Ainsi, si le pont de génération 80 est initialement préchargé à la deuxième tension prédéfinie $V_{DD}$, la mise en oeuvre d'une opération de calcul, c'est-à-dire l'activation d'une rangée 18 par sa ligne de mot WL et l'application des activations d'entrée sur les lignes de bit complémentaires BL/BL_B générera la décharge d'un condensateur équivalent de capacité *popcount XNOR(Wⱼ, xᵢ)* * $C_0$ à travers la deuxième résistance 71.

La grandeur de référence étant la tension $V_{pop\_b}$ de la deuxième ligne complémentaire connectée à la fois aux condensateurs 63 de capacité $C_0$ et à la deuxième résistance 71 d'impédance R, la variation au cours du temps de la grandeur de référence dépend d'une constante de temps égale à *popcount XNOR(Wⱼ, xᵢ)* * $RC_0$.

L'unité de comparaison 60 comprend par exemple deux comparateurs 72 et 74, à savoir un premier comparateur 72 et un deuxième comparateur 74.

Le premier comparateur 72 est configuré pour transformer la grandeur intermédiaire en un signal créneau pop_temp avec un front de changement d'état 205 à un instant temporel caractéristique $t_c$, comme illustré sur la figure 9.

A cet effet, le premier comparateur 72 est configuré pour recevoir en entrée la grandeur intermédiaire $V_{pop}$ et une tension de comparaison $V_{comp}$. La tension de comparaison $V_{comp}$ est par exemple choisie égale à $\frac{V_{DD}}{2}$.

Lors de la décharge du pont de conversion, lorsque la grandeur intermédiaire $V_{pop}$ devient inférieure à la tension de comparaison $V_{comp}$, le premier comparateur 72 engendre un basculement du signal créneau pop_temp, passant par exemple à une valeur supérieure à sa valeur initiale, le front de changement d'état 205 étant autrement dit un front montant.

La variation au cours du temps du signal créneau pop_temp est représentée pour plusieurs valeurs de popcount et pour n=5 sur les courbes 210 de la figure 9.

Pour une valeur de popcount donnée, l'instant temporel caractéristique $t_c$ est alors égal à

$$\left(n - popcount\ XNOR(W_j, x_j)\right) * \ln\left(\frac{V_{DD}}{V_{comp}}\right)RC_0$$ , où ln représente la fonction logarithme népérien.

Ainsi, une différence temporelle Δt entre deux instants temporels caractéristiques $t_c$ pour deux valeurs de popcount successives vaut $\ln\left(\frac{V_{DD}}{V_{comp}}\right)RC_0$.

L'homme du métier observera alors que cette différence temporelle Δt est indépendante du nombre n d'entrées du circuit électronique 10 et donc indépendante de la taille du neurone. La précision de la génération du signal créneau pop_temp est donc indépendante de la taille du neurone.

Le deuxième comparateur 74 est configuré pour transformer la grandeur de référence en un signal créneau pop_btemp avec un front de changement d'état 215 à un instant temporel de référence $t_{ref}$, comme illustré sur la figure 9.

A cet effet, le deuxième comparateur 74 est configuré pour recevoir en entrée la grandeur de référence $V_{pop\_b}$ et la tension de comparaison $V_{comp}$.

Lors de la décharge du pont de génération 80, lorsque la grandeur de référence $V_{pop\_b}$ devient inférieure à la tension de comparaison $V_{comp}$, le deuxième comparateur 74 engendre un basculement du signal créneau pop_btemp, passant à une valeur supérieure à sa valeur initiale, le front de changement d'état 215 étant autrement dit un front montant.

La variation au cours du temps du signal créneau pop_btemp est représentée pour plusieurs valeurs de popcount et pour n=5 sur les courbes 220 de la figure 9.

Pour une valeur de popcount donnée, l'instant temporel de référence $t_{ref}$ est donc égal à

$$popcount\ XNOR(W_j, x_j) * \ln\left(\frac{V_{DD}}{V_{comp}}\right)RC_0$$ .

Ainsi, une différence temporelle Δt entre deux instants temporels de référence $t_{ref}$ pour deux valeurs de popcount successives vaut donc aussi $\ln\left(\frac{V_{DD}}{V_{comp}}\right)RC_0$.

L'homme du métier observera alors que cette différence temporelle Δt est indépendante du nombre n d'entrées du circuit électronique 10 et donc indépendante de la taille du neurone. La précision de la génération du signal créneau popb_temp est donc indépendante de la taille du neurone.

L'unité de comparaison 60 est alors configurée pour comparer l'instant temporel caractéristique $t_c$ et l'instant temporel de référence $t_{ref}$.

Dans l'exemple de la figure 8, l'unité de comparaison 60 comprend en outre une bascule 76, telle qu'une bascule D (de l'anglais *Data*), c'est-à-dire une bascule comportant uniquement une entrée de données, notée D. La valeur de l'entrée D est recopiée sur la sortie, notée Q, à chaque front d'horloge.

L'entrée D de la bascule 76 est connectée en sortie du premier comparateur 72 pour recevoir le signal $pop_{temp}$, et l'horloge de la bascule 76 est connectée en sortie du deuxième comparateur 74 pour recevoir le signal $pop_{btemp}$. La sortie Q de la bascule 76 correspond au résultat a de l'opération de calcul.

Si l'instant temporel caractéristique $t_c$ est inférieur, c'est-à-dire antérieur, à l'instant temporel de référence $t_{ref}$, alors la valeur de l'entrée D de la bascule 76 est déjà à la valeur haute au front d'horloge correspondant à l'instant temporel de référence $t_{ref}$ de sorte que la valeur haute est alors recopiée sur la sortie Q de la bascule 76 à l'instant temporel de référence $t_{ref}$. Autrement dit, dans ce cas, la bascule 76 fournit la valeur haute représentative d'un « 1 » logique en tant que résultat, noté a, de l'opération de calcul, comme illustré sur la droite de la figure 8.

Inversement, si l'instant temporel caractéristique $t_c$ est supérieur, c'est-à-dire postérieur, à l'instant temporel de référence $t_{ref}$, alors la valeur de l'entrée D de la bascule 76 est encore à la valeur basse au front d'horloge correspondant à l'instant temporel de référence $t_{ref}$ de sorte que la valeur basse est alors recopiée sur la sortie Q de la bascule 76 à l'instant temporel de référence $t_{ref}$. Autrement dit, dans ce cas, la bascule 76 fournit la valeur basse représentatif d'un « 0 » logique en tant que résultat a de l'opération de calcul, comme également illustré sur la droite de la figure 8.

Dans cet exemple des figures 8 et 9, il ressort que :

$$t_c < t_{ref} \Leftrightarrow popcount\ XNOR\big(W_j, x_j\big) > \frac{n}{2}$$

Un « 1 » logique en sortie de la bascule 76 correspond à un popcount supérieur à n/2, c'est-à-dire que le nombre de valeurs hautes en sortie des unités logiques 42 est supérieur au nombre de valeurs basses.

Inversement, un « 0 » logique en sortie de la bascule 76 correspond à un popcount inférieur à n/2, c'est-à-dire que le nombre de valeurs hautes en sortie des unités logiques 42 est inférieur au nombre de valeurs basses.

Ainsi, le résultat de l'opération exécutée par le neurone est défini en fonction d'un seuil Th. Le résultat étant un « 1 » logique si le nombre de valeurs hautes est supérieur au seuil Th. Dans le cas décrit ci-dessus, le seuil Th est égal à n/2.

Lorsqu'en complément facultatif le circuit électronique 10 comprend la matrice supplémentaire 26 de cellules mémoire 12, aussi appelée matrice de biais 26, cette matrice de biais 26 permet d'obtenir un seuil Th différent de n/2, ainsi que cela va être décrit à présent.

La matrice de biais 26 comprend b colonnes 20 et m rangées 18, c'est-à-dire le même nombre de rangées 18 que la matrice 14. Les m rangées de la matrice de biais 26 sont chacune reliées à la ligne de mot WL de la rangée respective de la matrice 14.

Les cellules mémoire 12 d'une même colonne 20 de la matrice de biais 26 partagent la même paire de lignes de bit complémentaires BL et BLb et la même ligne de source SL.

Le nombre b de colonnes ajoutées est typiquement pair.

L'ajout de b colonnes de biais génère b+1 possibles valeurs de seuil Th différentes et centrées autour de n/2.

Similairement aux colonnes 20 de la matrice 14, chaque colonne 20 de la matrice de biais 26 est suivie d'une unité logique 42. On note p le nombre de colonne(s) 20 de la matrice de biais 26 dont la sortie de l'unité logique 42 respective correspond à un « 0 » logique.

Le nombre de « 0 » logique obtenu(s) en sortie des unités logiques 42 des colonnes 20 de la matrice de biais 26 est configuré par les poids W stockés dans les cellules mémoires 12 de la matrice de biais 26 étant sélectionnées par la ligne de mot WL, et activées par le signal d'entrée in amené à la cellule 12 sélectionnée via les lignes de bit BL et BLb associées.

Le module de conversion 44 et le générateur de tension de référence 66 sont étendus pour prendre en compte les sorties des unités logiques 42 supplémentaires de chaque colonne 20 de la matrice de biais 26. En d'autres termes, le module de conversion 44 comprend alors au total n+b premiers éléments 62 et n+b premiers commutateurs 64, et le générateur de tension de référence 66 comprend n+b deuxièmes éléments 68 et n+b deuxièmes commutateurs 70, lorsque le générateur de tension de référence 66 comprend le pont de génération 80.

Chaque premier élément 62 est relié à un premier commutateur 64 respectif et chaque deuxième élément 68 est relié à un deuxième commutateur 70 respectif, chaque commutateur 64, 70 activant ou inhibant l'élément 62, 68 comme décrit précédemment. Chaque premier élément 62, et respectivement chaque deuxième élément 68, sont selon ce complément facultatif avec matrice de biais 26 identiques aux premier 62, et respectivement deuxième 68, éléments décrits pour le cas précédent sans matrice de biais.

Le nombre de premier(s) élément(s) 62 activé(s) dans le module de conversion 44 est alors égal à *n - popcount XNOR($W_j$, $x_j$) + p.*

Ainsi, si le pont de conversion 78 est initialement préchargé à la première tension prédéfinie $V_{DD}$, la mise en œuvre d'une opération de calcul, c'est-à-dire de l'activation d'une rangée 18 par sa ligne de mot WL et l'application des activations d'entrée sur les lignes de bit complémentaires BL/BL$_B$, génèrera la décharge d'un condensateur équivalent de capacité ($n$ - *popcount XNOR*($W_j$, $x_j$) + $p$) * $C_0$ à travers la première résistance 65.

Pour une valeur de popcount donnée, l'instant temporel caractéristique $t_c$ du signal pop$_{temp}$ fourni par le premier comparateur 72 est donc égal à $\left(n - popcount\ XNOR(W_j, x_j) + p\right) * \ln(\frac{V_{DD}}{V_{comp}})RC_0$ .

Le nombre de deuxième(s) élément(s) 68 activé(s) dans le générateur de tension de référence 66 est donc égal à *popcount XNOR*($W_j$, $x_j$) + $b$ - $p$.

Ainsi, si le pont de génération 80 est initialement préchargé à la deuxième tension prédéfinie $V_{DD}$, la mise en oeuvre d'une opération de calcul, c'est-à-dire l'activation d'une rangée 18 par sa ligne de mot WL et l'application des activations d'entrée sur les lignes de bit complémentaires BL/BL$_B$ génèrera la décharge d'un condensateur équivalent de capacité (*popcount XNOR*($W_j$, $x_j$) + $b$ - $p$) * $C_0$ à travers la deuxième résistance 71.

Pour une valeur de popcount donnée, l'instant temporel de référence $t_{réf}$ du signal pop$_{btemp}$ fourni par le deuxième comparateur 74 est donc égale à $\left(popcount\ XNOR(W_j, x_j) + b - p\right) * \ln(\frac{V_{DD}}{V_{comp}})RC_0$ .

Par analogie avec le fonctionnement décrit ci-dessus, on en déduit qu'un instant temporel caractéristique $t_c$ inférieur à l'instant temporel de référence $t_{ref}$, et par conséquent une sortie Q de la bascule 76 représentatif d'un « 1 » logique est équivalent à :

$$t_c < t_{réf} \Leftrightarrow popcount\ XNOR(W_j, x_j) > \frac{n}{2} - \frac{b}{2} + p$$

Un « 1 » logique en sortie de la bascule 76 correspond à un popcount supérieur à $\frac{n}{2} - \frac{b}{2} + p$ .

Inversement, un « 0 » logique en sortie de la bascule 76 correspond à un popcount inférieur à $\frac{n}{2} - \frac{b}{2} + p$ .

Ainsi, lorsqu'en complément facultatif le circuit électronique 10 comprend en outre la matrice de biais 26, le seuil Th vaut $\frac{n}{2} - \frac{b}{2} + p$ . Le seuil Th dépend alors du nombre de colonnes b de biais et du nombre p de « 0 » logique en sortie des unités logiques 42 de chaque colonne de biais.

Pour $p = \frac{b}{2}$, c'est-à-dire si la moitié des sorties des unités logiques 42 des colonnes de biais correspondent à un « 0 » logique et l'autre moitié un « 1 » logique, le seuil Th est égal à $\frac{n}{2}$. On obtient donc un résultat équivalent à un circuit électronique 10 ne comprenant pas la matrice de biais 26.

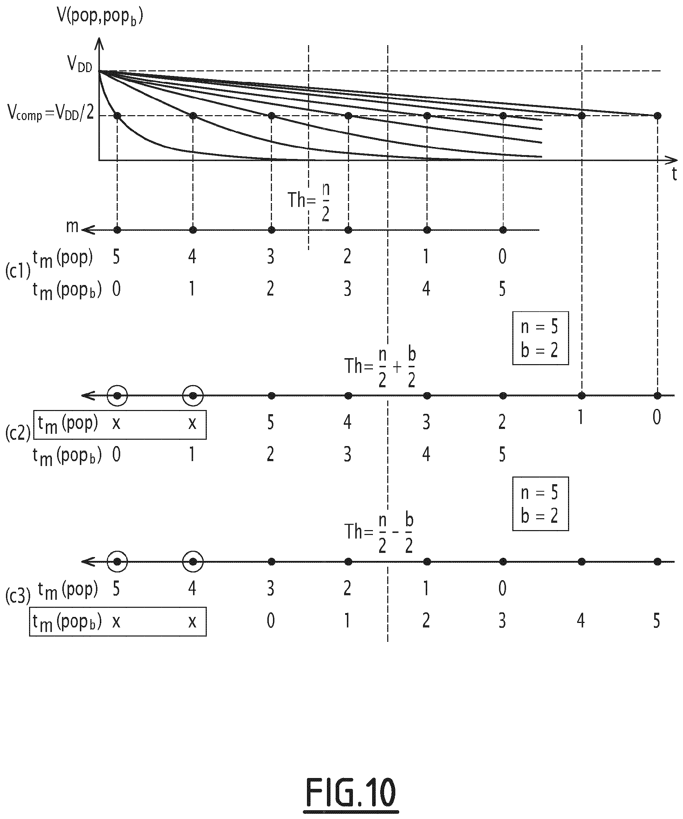

La figure 10 représente différents seuils Th possibles pour n=5 et b=2. Dans l'exemple de la figure 10, différentes valeurs possibles pour l'instant temporel caractéristique $t_c$ sont indiquées sur une ligne notée $t_m$(pop), et de manière analogue différentes valeurs possibles pour l'instant temporel de référence $t_{ref}$ sont indiquées sur une ligne notée $t_m$(pop$_b$).

Dans la configuration (c1), le circuit électronique 10 ne comprend pas la matrice de biais 26. On a donc $Th = \frac{n}{2}$ .

Dans la configuration (c2), la matrice de biais 26 comporte deux colonnes 20 de cellules mémoires 12. Les deux cellules mémoire 12 sélectionnées par la ligne de mot WL sont toutes les deux configurées pour obtenir un « 0 » logique en sortie de leur unité logique 42 respective, autrement dit p=2. Ainsi, l'instant temporel caractéristique $t_c$ obtenu avec le biais pour un popcount donné est décalé de 2*Δt par rapport à l'instant temporel caractéristique $t_c$ obtenu sans biais pour le même popcount, où Δt représente la différence temporelle entre deux instants temporels caractéristiques $t_c$ pour deux valeurs de popcount successives, telle que par exemple $\ln\left(\frac{V_{DD}}{V_{comp}}\right)RC_0$ . Ce décalage de 2*Δt est représenté par l'encadré pour la configuration (c2) à la figure 10. On a alors $Th = \frac{n}{2} - \frac{b}{2} + p = \frac{n}{2} + 1$ . L'instant temporel caractéristique $t_c$ correspond au seuil Th est représenté par le ligne pointillée remontant jusqu'au chronogramme.

Dans la configuration (c3), la matrice de biais 26 comporte aussi deux colonnes 20 de cellules mémoires 12. Les deux cellules mémoire 12 sélectionnées par la ligne de mot WL sont ici toutes les deux configurées pour obtenir un « 1 » logique en sortie de leur unité logique 42 respective, autrement dit p=0. Ainsi, l'instant temporel de référence $t_{ref}$ obtenu avec le biais pour un popcount donné est décalé de 2*Δt par rapport à l'instant temporel de référence $t_{ref}$ obtenu sans biais pour le même popcount, où Δt représente la différence temporelle précitée. Ce décalage de 2*Δt est représenté par l'encadré pour la configuration (c3) à la figure 10. On a alors $Th = \frac{n}{2} - \frac{b}{2} + p = \frac{n}{2} - 1$. L'instant temporel de référence $t_{ref}$ correspond au seuil Th est représenté par le ligne pointillée remontant jusqu'au chronogramme.

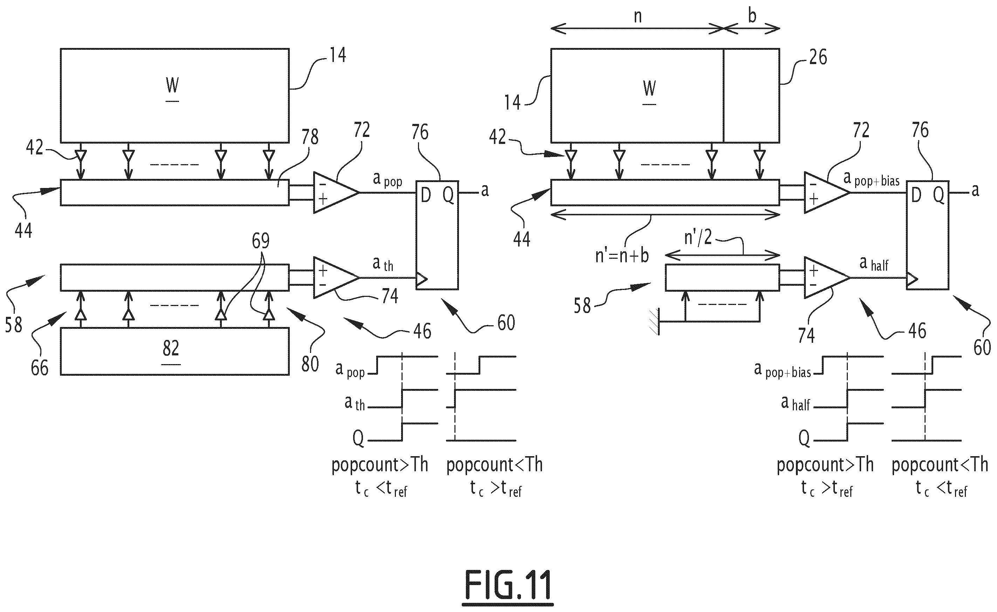

Des deuxième et troisième exemples de réalisation du circuit électronique 10 présentant un biais vont maintenant être décrits, en référence à la figure 11.

Les deuxième et troisième exemples diffèrent du premier exemple en ce qui concerne le générateur de tension de référence 66, et seules les différences entre le premier exemple décrit précédemment et les deuxième et troisième exemples de la figure 11 seront donc décrites ci-après.

Dans le deuxième exemple de réalisation illustré à gauche de la figure 11, le générateur de tension de référence 66 comprend le pont de génération 80 et une matrice complémentaire 82 de cellules mémoire 12. La différence entre ce deuxième exemple de réalisation et le premier exemple décrit précédemment est que le pont de génération 80 n'est pas connecté en sortie des unités logiques 42, le pont de génération 80 étant selon ce deuxième exemple connecté en sortie de ladite matrice complémentaire 82. Les deuxièmes commutateurs 70 ne sont donc pas commandés par les sorties de ces unités logiques 42, mais par la matrice complémentaire 82.

La matrice complémentaire 82 est configurée pour fournir n sorties aux deuxièmes commutateurs 70, n étant pour rappel le nombre de colonnes de la matrice 14. Chaque sortie peut prendre une valeur haute correspondant à un « 1 » logique ou une valeur basse correspondant à un « 0 » logique.

La matrice complémentaire 82 comprend n colonnes 20 comme la matrice 14 et au moins une rangée 18. Chaque cellule mémoire 12 d'une même rangée 18 partage la même ligne de mot WL. Les cellules mémoire 12 d'une même colonne 20 partagent la même paire de lignes de bit complémentaires BL et BLb et la même ligne de source SL.

Le nombre de « 1 » logique et de « 0 » logique en sortie de la matrice complémentaire 82 définit le seuil Th. On note r, le nombre de « 0 » compris dans la série de bits en sortie de la matrice complémentaire 82. De préférence r est compris entre $\frac{n}{2} - 10\%$ et $\frac{n}{2} + 10\%$ .

Le nombre de rangées 18 de la matrice complémentaire 82 est donc égal au nombre de valeurs de seuils souhaitées. La ligne de mot WL reliant la rangée de la matrice complémentaire 82 stockant les poids du seuil souhaité active le cellules mémoires 12 de ladite rangée 18.

Les deuxièmes commutateurs 70 selon ce deuxième exemple de réalisation sont identiques à ceux décrits précédemment pour le premier exemple, et comportent par exemple les inverseurs 69 visibles à la figure 11.

Par exemple, chaque deuxième commutateur 70 est configuré pour activer le deuxième élément 68 correspondant si la sortie de la matrice complémentaire 82 est représentative d'un « 0 » logique et inhiber l'élément correspond si ladite sortie est représentative d'un « 1 » logique.

Ainsi, si le pont de génération 80 est initialement préchargé à $V_{DD}$, la mise en œuvre d'une opération de calcul, c'est-à-dire de l'activation d'une rangée 18 par sa ligne de mot WL et l'application des activations d'entrée sur les lignes de bit complémentaires $BL/BL_B$ générera la décharge d'un condensateur équivalent de capacité $r * C_0$ à travers la résistance R.

L'instant temporel de référence $t_{ref}$ du signal $a_{th}$ fourni par le deuxième comparateur 74 selon ce deuxième exemple de réalisation est alors égal à $r * \ln(\frac{V_{DD}}{V_{comp}})RC_0$ .

L'instant temporel de référence $t_{ref}$ obtenu est comparé par la bascule 76 à l'instant temporel caractéristique $t_c$ du signal fourni par le premier comparateur 72, celui-ci étant noté ici $a_{pop}$ et obtenu en l'absence de matrice de biais 26, autrement dit $t_c = \left(n - popcount\ XNOR(W_j, x_j)\right) * \ln\left(\frac{V_{DD}}{V_{comp}}\right)RC_0$ .

D'après le raisonnement précédent, on a :

$$t_c < t_{réf} \Leftrightarrow popcount\ XNOR(W_j, x_j) > n - r$$

Le signal en sortie de la bascule 76 est donc représentatif d'un « 1 » logique si *popcount XNOR(W_j, x_j) > n - r*, et le signal en sortie de la bascule 76 est représentatif d'un « 0 » logique si *popcount XNOR(W_j, x_j) < n - r*.

Le seuil Th vaut donc n-r.

Selon une variante, chaque deuxième commutateur 70 est configuré pour activer le deuxième élément 68 correspondant si la sortie la matrice complémentaire 82 est représentative d'un « 1 » logique et inhiber le deuxième élément 68 correspondant si la sortie est représentative d'un « 0 » logique.

Ainsi, si le pont de génération 80 est initialement préchargé à $V_{DD}$, la mise en œuvre d'une opération de calcul, c'est-à-dire de l'activation d'une rangée 18 par sa ligne de mot WL et l'application des activations d'entrée sur les lignes de bit complémentaires BL/BL$_B$ générera la décharge d'un condensateur équivalent de capacité $(n - r) * C_0$ à travers la résistance R.

Le signal en sortie de la bascule 76 est donc représentatif d'un « 1 » logique si *popcount XNOR(W$_j$, x$_j$) > r,* et le signal en sortie de la bascule 76 est représentatif d'un « 0 » logique si *popcount XNOR(W$_j$, x$_j$) < r.*

Le seuil Th vaut donc r.

L'homme du métier observera que la matrice complémentaire 82 permet alors de commander le pont de génération 80 de manière indépendante de la matrice 14, ce qui permet de générer la valeur de seuil Th souhaitée, sans avoir une matrice de biais 26 associée à la matrice 14 de cellules mémoire 12. Cela nécessite toutefois que chaque ligne de la matrice complémentaire 82 corresponde à un seuil différent pour couvrir les $\frac{n}{2} \pm 10\%$ de biais nécessaires.

Dans le troisième exemple de réalisation illustré à droite de la figure 11, le circuit électronique 10 comprend la matrice supplémentaire de biais 26, cette dernière comprenant b colonnes 20.

Le générateur de tension de référence 66 comprend une pluralité d'unité de génération 67. Dans l'exemple de la figure 11, le générateur de tension de référence 66 comprend $\frac{n+b}{2}$ unités de génération 67.

Chaque unité de génération 67 présente une entrée, et les entrées de toutes les unités de conversion sont reliées au même potentiel, par exemple à la masse électrique GND. Chaque unité de génération 67 selon ce troisième exemple de réalisation est identique à une unité de génération 67 respective décrite selon le premier exemple de réalisation.

Les unités de génération 67 sont connectées en parallèle entre la tension V$_{DD}$ et la tension V$_{pop\_b}$.

Dans le cas où les premiers éléments 62 du module de conversion 44 sont des condensateurs 63, le générateur de tension comprend en outre une résistance R.

Ainsi, le pont de génération 80 est initialement préchargé à V$_{DD}$, la mise en oeuvre d'une opération de calcul générera la décharge d'un condensateur équivalent de capacité $\frac{n+b}{2} * C_0$ à travers la résistance R.

L'instant temporel de référence t$_{ref}$ du signal a$_{half}$ fourni par le deuxième comparateur 74 selon ce troisième exemple de réalisation est donc égal à $\frac{n+b}{2} * \ln(\frac{V_{DD}}{V_{comp}})RC_0$.

L'instant temporel de référence t$_{ref}$ obtenu est comparé par la bascule 76 à l'instant temporel caractéristique t$_c$ du signal fourni par le premier comparateur 72, celui-ci étant noté ici a$_{pop+bias}$ et obtenu en considérant que p est le nombre de colonnes de biais dont la sortie de l'unité logique 42 respective correspond à un « 0 » logique, autrement dit

$$t_c = \left(n - popcount\ XNOR\left(W_j, x_j\right) + p\right) * \ln\left(\frac{V_{DD}}{V_{comp}}\right)RC_0 \ .$$

D'après le raisonnement précédent, on a :

$$t_c < t_{réf} \Leftrightarrow popcount\ XNOR\left(W_j, x_j\right) > \frac{n}{2} + p - \frac{b}{2}$$

On obtient un seuil $Th = \frac{n}{2} + p - \frac{b}{2}$.

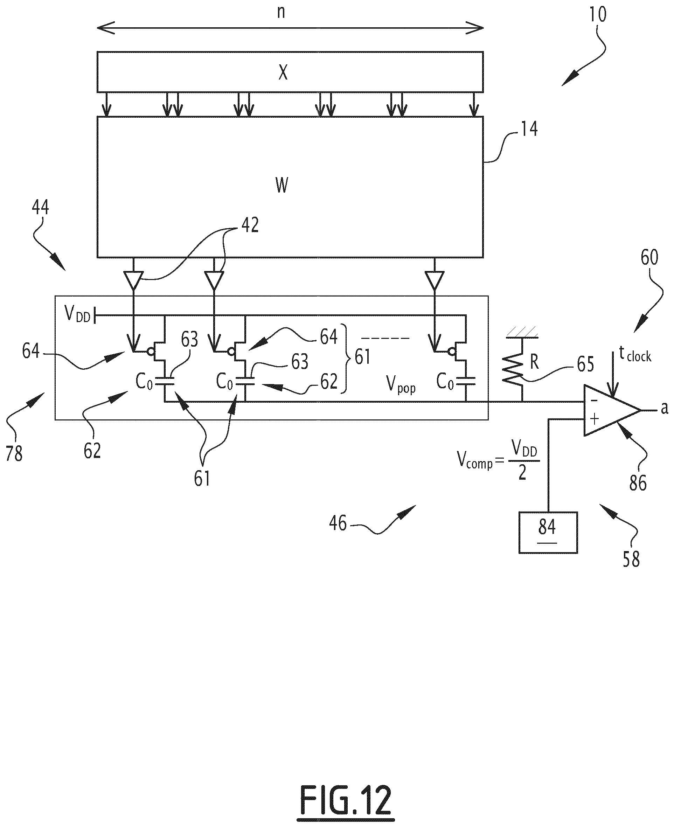

Un quatrième exemple de réalisation du circuit électronique 10 va maintenant être décrit, en référence à la figure 12. Seules les différences entre les premier et quatrième exemples de réalisation sont décrites ci-après.

Selon la figure 12, l'unité d'obtention 58 comprend une source de tension 84 fournissant une tension fixe de comparaison V$_{comp}$, de valeur constante, en entrée de l'unité de comparaison 60. De préférence, la tension de comparaison V$_{comp}$ est égale à V$_{DD}$/2.

Dans l'exemple de la figure 12, l'unité de comparaison 60 comprend un comparateur 86 avec une référence d'horloge, appelé par la suite comparateur clocké 86, qui prend en entrée la grandeur intermédiaire issue du module de conversion 44 à sa borne négative et la tension de comparaison V$_{comp}$ issue de l'unité d'obtention 58, et en particulier de la source de tension 84, à sa borne positive, et génère en sortie un signal a représentatif d'un « 1 » logique ou d'un « 0 » logique.

La grandeur intermédiaire est la tension du pont de conversion 78, notée V$_{pop}$ dont la variation au cours du temps dépend d'une constante de temps égale à $\left(n - popcount\ XNOR\left(W_j, x_j\right)\right) * RC_0$.

L'instant temporel caractéristique t$_c$ est défini comme l'instant à partir duquel la tension V$_{pop}$ est inférieur à la tension de comparaison V$_{comp}$ :

$$V_{pop} < V_{comp} \iff t > t_c \text{ , avec } t_c = \left(n - popcount\, XNOR\left(W_j, x_j\right)\right) \ln\left(\frac{V_{DD}}{V_{comp}}\right) RC_0$$

Le front d'horloge du comparateur clocké 86 est fixé à une référence horloge $t_{clock}$ configurée pour que si $t_c < t_{clock}$, le résultat de calcul neuronal vaut 1, donc le signal a en sortie du comparateur clocké 86 est représentatif d'un « 1 » logique et si $t_c > t_{clock}$, le résultat de calcul neuronal vaut 0, donc le signal a en sortie du comparateur clocké 86 est représentatif d'un « 0 » logique.

La valeur de la référence horloge $t_{clock}$ permet alors de définir un seuil Th fixe, tel que :

$$t_c < t_{clock} \iff popcount > Th, \qquad Th = n - \frac{t_{clock}}{\ln\left(\frac{V_{DD}}{V_{comp}}\right) RC_0}$$

Par exemple, pour avoir un seuil Th de $\frac{n}{2}$, on fixe le front d'horloge à la référence horloge

$$t_{clock} = \frac{n}{2} \ln\left(\frac{V_{DD}}{V_{réf}}\right) RC_0 .$$

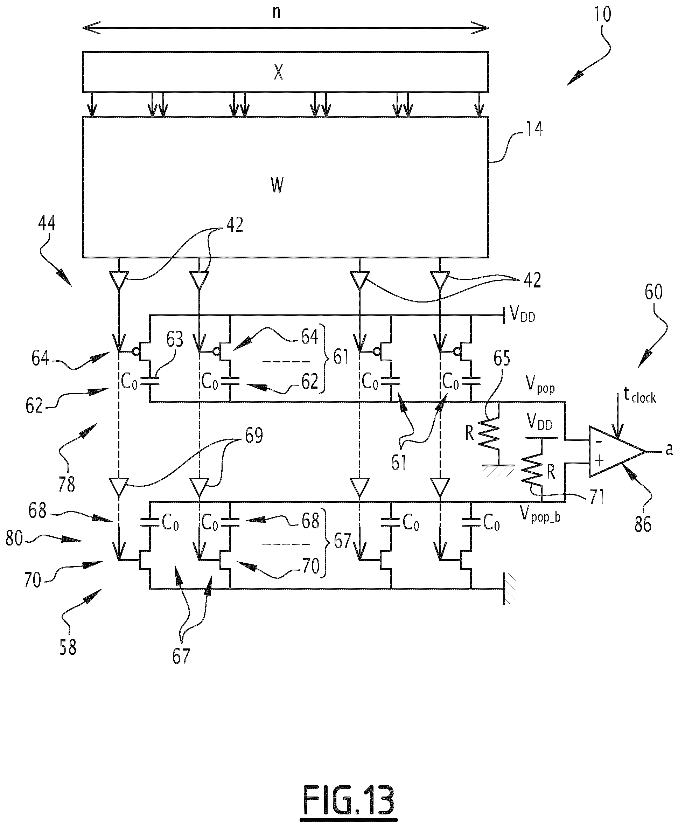

Un cinquième exemple de réalisation du circuit électronique 10 va maintenant être décrit, en référence à la figure 13. Seules les différences entre les quatrième et cinquième exemples de réalisation sont décrites ci-après.

Dans l'exemple de la figure 13, le générateur de tension de référence 66 est le pont de génération 80, symétrique au pont de conversion 78 du module de conversion 44.

Le générateur de tension de référence 66 est alors obtenu via un ensemble de mêmes deuxièmes éléments 68 reliés entre eux et un ensemble de deuxièmes commutateurs 70, les deuxièmes éléments 68 étant identiques aux premiers éléments 62 de l'ensemble du module de conversion 44. L'homme du métier observera que dans l'exemple de la figure 13, les deuxièmes commutateurs 70 ont typiquement une logique de commande inversée par rapport aux deuxièmes commutateurs 70 de l'exemple de la figure 8. Dans l'exemple de la figure 8, chaque deuxième commutateur 70 comporte typiquement un transistor NMOS ; et dans l'exemple de la figure 13, chaque deuxième commutateur 70 comporte typiquement un transistor PMOS.

Dans l'exemple de la figure 13, chaque premier élément 62 du module de conversion 44 comprend un condensateur 63 de capacité $C_0$, et chaque deuxième élément 68 comprend un condensateur 63 de capacité $C_0$.

Le générateur de tension de référence 66 comprend en outre la deuxième résistance 71 d'impédance R, identique à la première résistance 65 du module de conversion 44 et connectée à la tension $V_{DD}$.

Ainsi, si le pont de génération 80 est initialement déchargé, la mise en oeuvre d'une opération de calcul, c'est-à-dire de l'activation d'une rangée 18 par sa ligne de mot WL et l'application des activations d'entrée sur les lignes de bit complémentaires BL/BL$_B$ générera la charge d'un condensateur équivalent de capacité $(n - popcount\, XNOR(W_j, x_j)) * C_0$ à travers la deuxième résistance 71 d'impédance R.

La grandeur de référence étant la tension $V_{pop\_b}$ du pont de génération 80, la variation au cours du temps de la grandeur de référence dépend d'une constante de temps égale à $(n - popcount\, XNOR(W_j, x_j)) * RC_0$. Cette constante de temps est égale à la constante de temps de variation de la grandeur intermédiaire fournie par le module de conversion 44.

Les tensions $V_{pop}$ et $V_{pop\_b}$ présentent un point d'intersection pour une valeur de tension de l'ordre de $\frac{V_{DD}}{2}$.

Le comparateur clocké 86 prend en entrée la grandeur intermédiaire $V_{pop}$ issue du module de conversion 44 à sa borne négative et la grandeur de référence $V_{pop\_b}$ à sa borne positive, et génère en sortie un signal a représentatif d'un « 1 » logique ou d'un « 0 » logique.

L'instant temporel caractéristique $t_c$ est défini comme l'instant à partir duquel la tension $V_{pop}$ est inférieure à la tension de référence $V_{pop\_b}$ :

$$V_{pop} < V_{popb} \iff t > t_c \text{ , avec } t_c = \left(n - popcount\, XNOR\left(W_j, x_j\right)\right) \ln(2)\, RC_0$$

Le front d'horloge du comparateur clocké 86 est fixé à la référence d'horloge $t_{clock}$ configurée pour que si $t_c < t_{clock}$, le résultat de calcul neuronal vaut 1, donc le signal a en sortie du comparateur clocké 86 est représentatif d'un « 1 » logique, et si $t_c > t_{clock}$, le résultat de calcul neuronal vaut 0, donc le signal a en sortie du comparateur clocké 86 est représentatif d'un « 0 » logique.

La valeur de la référence d'horloge $t_{clock}$ permet de définir un seuil Th fixe tel que :

$$t_c < t_{clock} \Leftrightarrow popcount > Th, \qquad Th = n - \frac{t_{clock}}{\ln(2)\,RC_0}$$

Par exemple, pour avoir un seuil Th de $\frac{n}{2}$, on fixe le front d'horloge à la référence d'horloge $t_{clock} = \frac{n}{2}\ln(2)\,RC_0$.

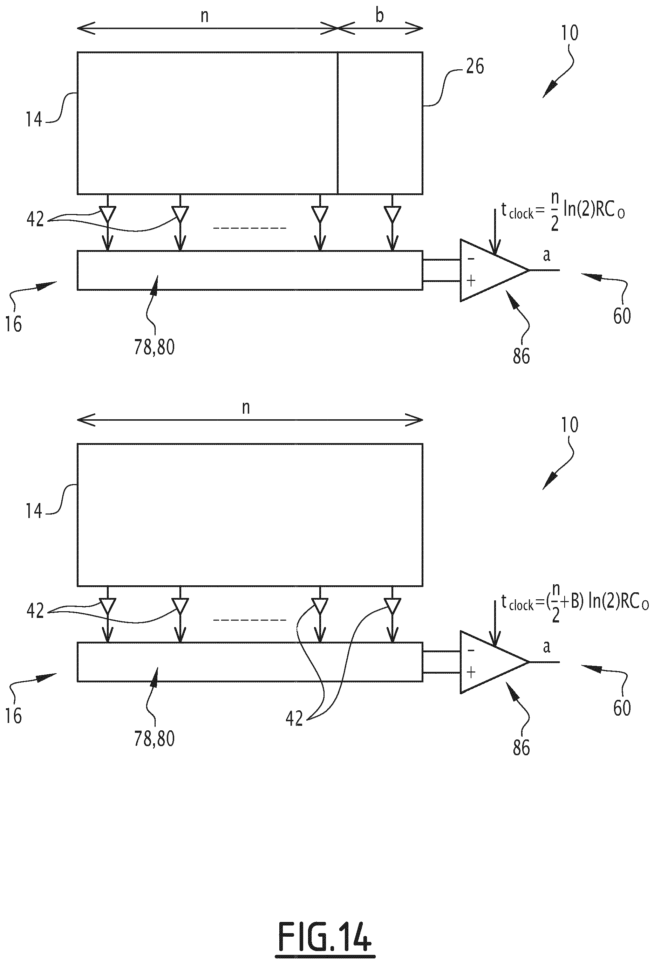

Des sixième et septième exemples de réalisation d'un circuit électronique 10 avec biais pour décaler la valeur de seuil Th, et avec l'une unité de comparaison 60 comprenant le comparateur clocké 86 vont maintenant être décrits, en référence à la figure 14.

Seules les différences entre le cinquième exemple décrit précédemment et les sixième et septième exemples de la figure 14 seront donc décrites ci-après.

Dans le sixième exemple de réalisation illustré en haut de la figure 14, le circuit électronique 10 comprend la matrice de biais 26.

La matrice de biais 26 comprend b colonnes 20 de cellules mémoires 12.

Le front d'horloge du comparateur clocké 86 est fixe et a la référence d'horloge $t_{clock}$. De préférence, la référence d'horloge $t_{clock}$ est définie telle que que le seuil Th en l'absence de biais soit de $\frac{n}{2}$. C'est-à-dire $t_{clock} = \frac{n}{2}\ln(2)\,RC_0$.

Le générateur de tension de référence 66 est par exemple le pont de génération 80, symétrique du pont de conversion 78 du module de conversion 44, mais en charge.

La grandeur de référence étant la tension $V_{pop\_b}$ du pont de génération 80, la variation au cours du temps de la grandeur de référence $V_{pop\_b}$ dépend alors d'une constante de temps égale à $(n - popcount\ XNOR(W_j, x_j) + p) * RC_0$. Pour rappel, p est le nombre de colonnes de biais dont la sortie de l'unité logique 42 respective correspond à un « 0 » logique. Cette constante de temps est égale à la constante de temps de variation de la grandeur intermédiaire $V_{pop}$ fournie par le module de conversion 44.

On en déduit l'instant temporel caractéristique $t_c$ :

$$V_{pop} < V_{popb} \Leftrightarrow t > t_c \text{, avec } t_c = \left(n - popcount\ XNOR\left(W_j, x_j\right) + p\right)\ln(2)\,RC_0$$

$$t_c < t_{clock} \Leftrightarrow popcount > Th, \qquad Th = n + p - \frac{t_{clock}}{\ln(2)\,RC_0}$$

Ainsi, si a référence d'horloge $t_{clock} = \frac{n}{2}\ln(2)\,RC_0$, le seuil Th vaut $\frac{n}{2} + p$.

La matrice de biais 26 permet donc d'obtenir différentes valeurs de seuil en fonction du nombre p de colonnes de biais dont la sortie de l'unité logique 42 respective correspond à un « 0 » logique. On a donc $0 \le p \le b$, ce qui correspond à b+1 valeurs de seuil Th possibles centrées autour de $\frac{n}{2}$.

Dans le septième exemple de réalisation illustré en bas de la figure 14, le signal d'horloge du comparateur clocké 86 est variable $t_{clock} = \left(\frac{n}{2} + B\right)\ln(2)\,RC_0$.

La valeur B est un entier naturel et permet d'obtenir un seuil Th variable dépendant de la valeur B :
$$Th = \frac{n}{2} + B.$$

De préférence,

$$-\frac{n}{2} * 10\% \le B \le \frac{n}{2} * 10\%.$$

Les exemples de réalisation du circuit électronique 10 décrits ci-dessus ne sont pas limitatifs et sont données uniquement à titre d'exemples. Toutes combinaisons de caractéristiques, décrites par les exemples précédents et suivants, techniquement possibles, correspondent également à l'invention.

En particulier, l'unité de comparaison 60 comprend par exemple le comparateur clocké 86 ; ou encore la bascule 76 ainsi que les premier et deuxième comparateurs 72 et 74.

De même, l'unité d'obtention 58 comprend par exemple le générateur de tension de référence 66 comme représenté sur la figure 8 ; ou encore la source de tension 84 fournissant la tension fixe de comparaison $V_{comp}$ en entrée de l'unité de comparaison 60 comme représenté sur la figure 12.

Le générateur de tension de référence 66 est par exemple réalisé par le pont de génération 80, symétrique au pont de conversion 78 du module de conversion 44, le pont de génération 80 étant commandé par la matrice 14, comme représenté sur la figure 8 ; ou encore par le pont de génération 80 commandé par la matrice complémentaire 82, comme illustré à gauche de la figure 11.

De plus, le pont de génération 80, symétrique du pont de conversion 78, peut-être configuré pour être équivalent à une charge ou une décharge d'un condensateur.

Dans le cas où l'unité de comparaison 60 comprend la bascule 76, un biais peut être ajouté au seuil Th grâce à l'ajout de la matrice de biais 26 ou via la matrice complémentaire 82.

Le générateur de tension de référence 66 peut aussi comprendre un demi-pont formé par $\frac{n+b}{2}$ unités de génération 67 en cas de présence de la matrice de biais 26.

Dans le cas où l'unité de comparaison 60 comprend un comparateur clocké 86, le seuil Th peut être modifié par la présence d'un biais par l'ajout de la matrice de biais 26 si le temps d'horloge du comparateur clocké 86 est fixe, ou encore via la variation du temps d'horloge en fonction du biais souhaité.

Le circuit électronique 10 selon l'invention comprend donc le module de comparaison 46 défini selon toutes combinaisons techniquement possibles des caractéristiques décrites ci-dessus.

Une variante supplémentaire combinable avec les exemples de réalisation décrits ci-avant est illustrée par un huitième exemple de réalisation en référence à la figure 15. Seules les différences entre le cinquième exemple de réalisation et le huitième exemple de réalisation seront décrites ci-dessous.

Dans l'exemple de la figure 15, les unités de conversion 61 du module de conversion 44 sont connectées en série.

Chaque unité de conversion 61 comprend le premier élément 62 et le premier commutateur 64 connectés en parallèle.

Chaque premier élément 62 comprend une résistance 88 de résistance $R_0$ et chaque premier commutateur 64 comprend un interrupteur 90 configuré par activer ou inhiber la résistance 88 correspondante.

En particulier, si un « 0 » logique est calculé en sortie d'une unité logique 42, le premier commutateur 64 respectif est configuré pour activer le premier élément 62 correspondant, donc l'interrupteur 90 est ouvert ; et si un « 1 » logique est calculé en sortie d'une unité logique 42 respective, le premier commutateur 64 respectif est configuré pour inhiber le premier élément 62 correspondant, donc l'interrupteur 90 est fermé.

La résistance 88 située en sortie de la première colonne 20 est connectée à la masse électrique GND et la résistance 88 située en sortie de la dernière colonne 20 est connectée en entrée de l'unité de comparaison 60.

Le module de conversion 44 comprend en outre un premier condensateur 92 de capacité C connecté entre l'entrée de l'unité de comparaison 60 et le potentiel $V_{DD}$.

Ainsi, si le pont de conversion 78 est initialement préchargé au potentiel $V_{DD}$, la mise en oeuvre d'une opération de calcul, c'est-à-dire de l'activation d'une rangée 18 par sa ligne de mot WL et des entrées sur les lignes de bit complémentaires BL/$BL_B$ générera la décharge du condensateur de capacité C à travers une résistance équivalente de résistance $(n - popcount\ XNOR(W_j, x_j)) * R_0$.

La grandeur intermédiaire étant la tension $V_{pop}$ du pont de conversion 78, la variation au cours du temps de la grandeur intermédiaire dépend d'une constante de temps égale à $(n - popcount\ XNOR(W_j, x_j)) * CR_0$.

Les résistances 88 des premiers éléments 62 formant le pont de conversion 78 sont reliées en série entre la masse électrique GND et la tension $V_{pop}$.

De même, chaque deuxième élément 68 du générateur de tension de référence 66 formé le pont de génération 80, symétrique du pont de conversion 78 du module de conversion 44, comprend la résistance 88 de résistance $R_0$ et chaque deuxième commutateur 70 comprend l'interrupteur 90 en parallèle de la résistance 88.

Les résistances 88 des deuxièmes éléments 68 formant le pont de génération 80 sont reliées en série entre un potentiel $V_A$ et la tension $V_{pop\_b}$.

Le générateur de tension de référence 66 comprend un outre un deuxième condensateur 94 de capacité C connecté entre la tension $V_{pop\_b}$ et un potentiel $V_B$.

Les valeurs des potentiels $V_A$ et $V_B$, ainsi que la logique de commande des deuxièmes commutateurs 70, sont définies en fonction de la charge ou décharge du deuxième condensateur 94 lors de la mise en œuvre d'un calcul neuronal.

Ainsi tout chose égale par ailleurs, tous les exemples de réalisation précédents sont techniquement possibles en utilisant des résistances 88 en tant que premiers éléments 62, et le cas échéant deuxièmes éléments 68, au lieu des condensateurs 63.

Les étapes de calcul décrites ci-dessus restent valables en remplaçant $C_0$ par $R_0$, et respectivement C par R.

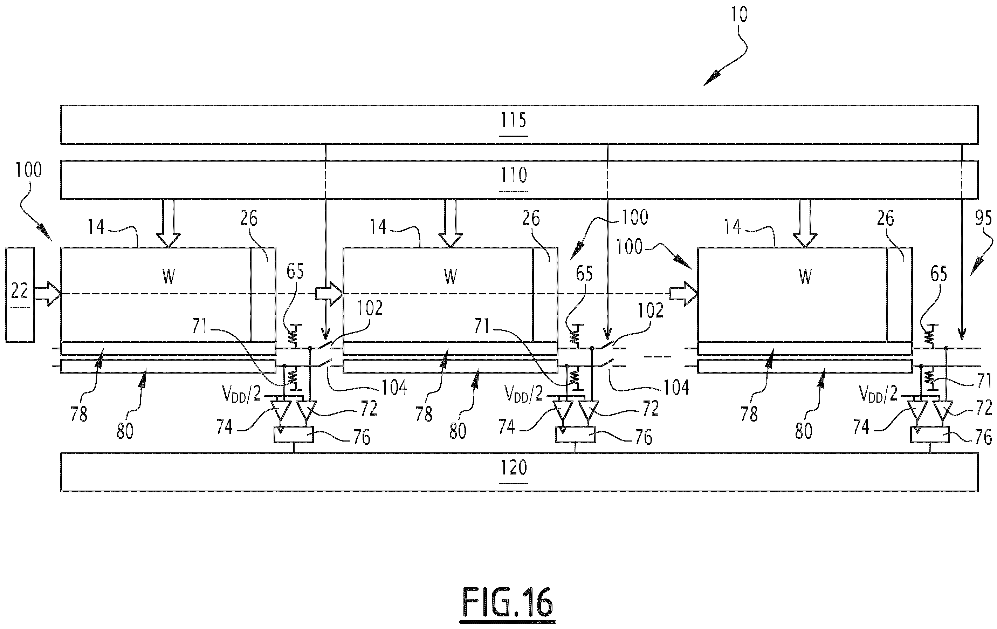

Le grand avantage que présente l'invention est la possibilité d'implémenter un neurone binaire dont la précision est indépendante de la taille du neurone. Cela permet d'implémenter des neurones très grands avec une très bonne précision, avec juste en contrepartie un temps de calcul possiblement plus long. Comme les tailles des neurones implémentés peuvent varier d'une architecture de réseau de neurones à l'autres et même d'une couche à l'autre, le circuit électronique 10 selon l'invention présente optionnellement et avantageusement une architecture en sous-banc 95 sous forme d'une rangée de nœuds neuronaux où chaque nœud neuronal 100 est configuré pour mettre en œuvre un neurone respectif et où les neurones ont des tailles minimales de x entrées, comme illustré sur la figure 16.

Dans l'exemple de la figure 16, chaque nœud neuronal 100 comprend la matrice 14 de cellules mémoire résistive 12 pour stocker les poids, et optionnellement la matrice de biais 26 ; le pont de conversion 78 et la première résistance 65 associée, et optionnellement le pont de génération 80 et la deuxième résistance 71 associée ; les premier et deuxième comparateurs 72, 74 et la bascule 76.

Les nœuds neuronaux 100 sont alors aptes à être raccordés entre eux par des premiers interrupteurs 102 pour mettre en série les ponts de conversion 78, et optionnellement par des deuxièmes interrupteurs 104 pour mettre en série les ponts de génération 80, ceci afin de mettre en œuvre des neurones plus grands. Le raccordement entre deux nœuds neuronaux 100 de taille minimale x est simple, car il suffit juste de connecter leurs ponts de conversion 78, et respectivement leurs ponts de génération 80, entre eux pour mettre en œuvre un neurone de taille 2x. Il faut cependant veiller à connecter qu'une seule résistance de décharge 65, 71 par pont 78, 80.

Le contrôle d'une telle architecture en nœuds neuronaux 100 est simple comme le montre la figure 10, avec un contrôle commun des lignes de mots WL via le premier contrôleur 22 ; un registre d'activation d'entrée 110 apte à stocker les entrées ; un registre 115 de contrôle des connexions entre nœuds neuronaux 100, alors apte à commander les premiers et deuxièmes interrupteurs 100, 102 ; et un registre de sortie 120 récupérant les activations de sortie de tous les nœuds neuronaux 100 en parallèle.

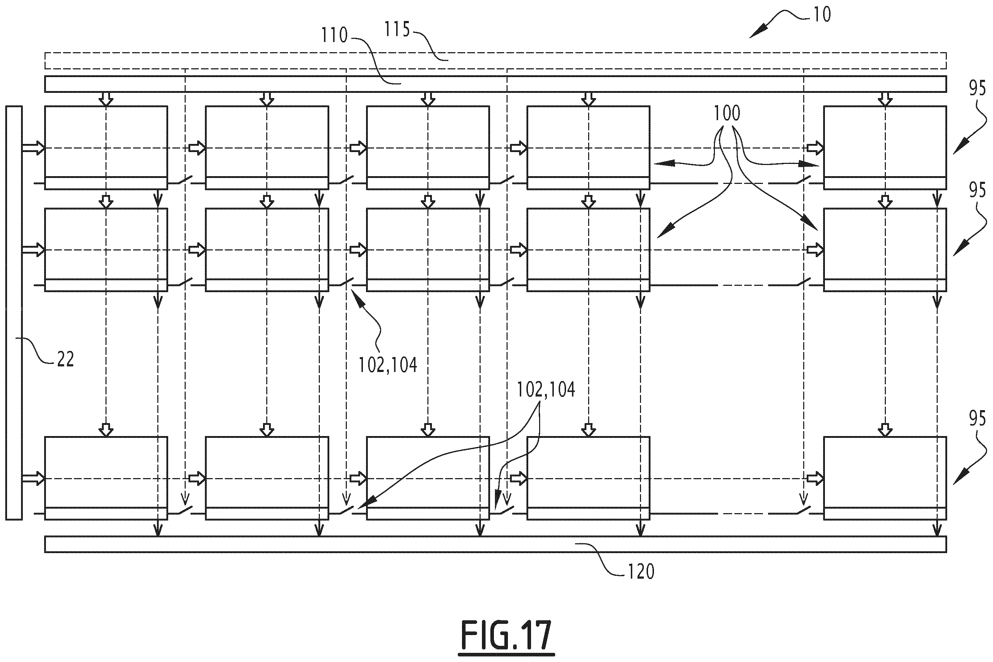

La figure 17 illustre l'architecture d'un banc construit à partir de plusieurs sous-bancs 95, chaque sous-banc 95 étant du type de celui décrit précédemment en regard de la figure 16. Les sous-bancs 95 partagent le même registre d'activation d'entrée 110 et le même registre 115 de contrôle des connections entre nœuds neuronaux 100, et les sorties des nœuds neuronaux 100 sont multiplexées pour être capturées par le registre commun de sortie 120 récupérant les activations des sorties. Ce contrôle peut être complexifié pour une plus grande granularité de contrôle.

L'invention offre alors une grande flexibilité de cartographie des poids et des neurones :

- un neurone par nœud neuronal 100 si les neurones sont petits ;
- un neurone sur plusieurs nœuds neuronaux 100 si le nombre d'entrées des neurones est trop élevé pour utiliser un seul nœud neuronal 100 ;
- les mêmes neurones avec plusieurs entrées en parallèle en dupliquant les poids sur plusieurs nœuds neuronaux 100.

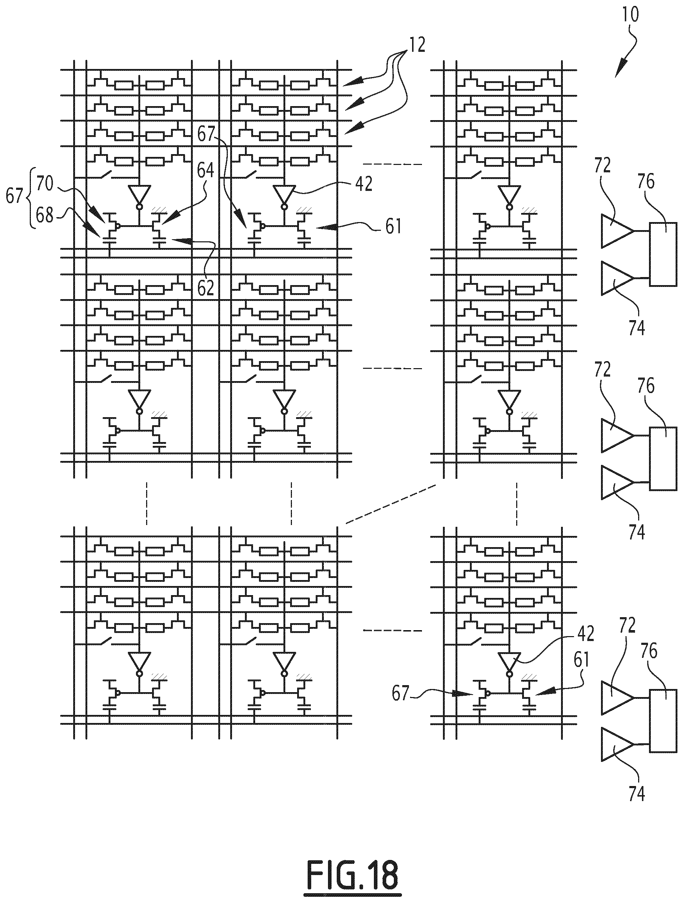

Une autre variante consiste à intégrer les premiers éléments 62 et commutateurs 64, et respectivement les deuxièmes éléments 68 et commutateurs 70, directement au sein de la matrice 14 de cellules mémoire 12, comme illustré sur la figure 18. Il est à noter que la précharge des extrémités des premiers éléments 62, respectivement des deuxièmes éléments 68, par exemple en forme de condensateurs 63, peut se faire simplement en appliquant un signal au potentiel GND, suivi d'un signal au potentiel $V_{DD}$ sur la ligne de source commune, ce qui permettra de précharger les nœuds internes des premiers commutateurs 64, suivi de ceux des deuxièmes commutateurs 70.

On conçoit ainsi que le circuit électronique 10 selon l'invention permet de réaliser un réseau de neurones binaire avec des cellules mémoire résistive 12 et pour des neurones de taille plus importante, c'est-à-dire avec un nombre plus élevé d'entrées.

## Revendications

1.   Circuit électronique (10) propre à mettre en œuvre des opérations de calcul fournissant chacune une sortie binaire, le circuit comprenant :

   - des lignes de mot (WL) ;
   - des paires de lignes de bit complémentaires (BL, BLb) ;
   - des lignes de source (SL) ;
   - un ensemble de cellules mémoire (12) organisées selon une matrice (14) comportant des rangées (18) et des colonnes (20), les cellules mémoire (12) d'une même rangée (18) étant sélectionnables par une ligne de mot (WL), les cellules mémoire (12) d'une même colonne (20) étant reliées à une paire de lignes de bit complémentaires (BL, BLb) et à une ligne de source (SL) ;
   chaque cellule mémoire (12) comprenant deux memristors et deux commutateurs, chaque memristor étant relié à la même ligne de source (SL) et à un commutateur respectif, chaque memristor mémorisant respectivement un poids ou l'inverse du même poids en présentant respectivement des première et deuxième valeurs de résistances différentes ; les commutateurs étant reliés, pour leur activation, à une ligne de mot (WL) respective et reliés respectivement à une paire de lignes de bit complémentaires (BL, BLb) ;
- un dispositif de lecture (16) mis en œuvre lors de chaque opération de calcul, le dispositif de lecture (16) comportant :

+ une unité logique (42) pour chaque colonne (20), chaque unité logique (42) comprenant une borne d'entrée connectée à une ligne de source (SL) respective pour recevoir une valeur d'entrée, l'unité logique (42) étant configurée pour effectuer une opération logique présentant un basculement entre une valeur basse et une valeur haute en fonction uniquement de la valeur de l'entrée de l'unité logique qui est connectée à la ligne de source (SL) lors de ladite opération de calcul,

**caractérisé en ce que** le dispositif de lecture (16) comporte en outre :

+ un module de conversion (44) configuré pour convertir un nombre de valeurs hautes ou basses en sortie des unités logiques (42) en une grandeur intermédiaire dépendant dudit nombre de valeurs hautes ou basses en sortie des unités logiques (42), la grandeur intermédiaire est une grandeur électrique, telle qu'une tension électrique, dont la variation au cours du temps dépend d'une constante de temps (RC), et la valeur de la constante de temps est fonction du nombre de valeurs hautes ou basses en sortie des unités logiques (42), le module de conversion (44) comportant un ensemble de mêmes éléments (62) reliés entre eux et un ensemble de commutateurs (64), chaque élément (62) étant associé à la sortie d'une unité logique (42) respective, chaque commutateur (64) étant connecté en sortie d'une unité logique (42) respective et configuré pour activer, ou respectivement inhiber, l'élément correspondant (62) selon la valeur haute ou basse en sortie de l'unité logique (42) respective, et la valeur de la constante de temps dépendant du nombre d'éléments (62) activés, et
+ un module de comparaison (46) configuré pour comparer la grandeur intermédiaire à une grandeur de référence et pour émettre en sortie un signal numérique sur un bit, dépendant de la comparaison et correspondant à la sortie du circuit électronique (10), le signal émis étant représentatif du résultat de l'opération de calcul.

2. Circuit électronique (10) selon la revendication 1, dans lequel la valeur de la constante de temps est directement proportionnelle au nombre de valeurs hautes ou basses en sortie des unités logiques (42).

3. Circuit électronique (10) selon l'une quelconque des revendications précédentes, dans lequel la valeur de la constante de temps est égale au produit d'une capacité et d'une résistance, l'une parmi la capacité et la résistance étant prédéfinie, et l'autre parmi la capacité et la résistance dépendant du nombre de valeurs hautes ou basses en sortie des unités logiques (42).

4. Circuit électronique (10) selon l'une quelconque des revendications précédentes, dans lequel chaque élément (62) est une résistance (88) ou un condensateur (63).

5. Circuit électronique (10) selon l'une quelconque des revendications précédentes, dans lequel l'ensemble de mêmes éléments est placé entre un premier potentiel d'alimentation ($V_{DD}$ ; GND) et un noeud intermédiaire ($V_{pop}$), et le module de conversion (44) comporte en outre un élément complémentaire placé entre le noeud intermédiaire ($V_{pop}$) et un second potentiel d'alimentation (GND ; $V_{DD}$).

6. Circuit électronique (10) selon les revendications 4 et 5, dans lequel lorsque chaque élément (62) est un condensateur (63), l'élément complémentaire est une résistance (65) ;
dans lequel lorsque chaque élément (62) est une résistance (88), l'élément complémentaire est un condensateur (92).

7. Circuit électronique (10) selon l'une quelconque des revendications précédentes, dans lequel le module de comparaison (46) est configuré pour transformer la grandeur intermédiaire en un signal créneau avec un front de changement d'état à un instant temporel caractéristique ($t_c$), l'instant temporel caractéristique ($t_c$) étant alors comparé à un instant temporel de référence ($t_{ref}$) associé à la grandeur de référence, et le signal représentatif du résultat de l'opération de calcul dépendant alors de ladite comparaison.

8. Circuit électronique (10) selon la revendication 5, dans lequel la grandeur intermédiaire est transformée en le signal créneau via un comparateur (72).

9. Circuit électronique (10) selon la revendication 6, dans lequel le module de comparaison (46) comporte le comparateur (72) et un générateur de tension de comparaison ($V_{comp}$), et le comparateur (72) est apte à comparer la tension générée à la tension de comparaison issue du générateur de tension de comparaison.

10. Circuit électronique (10) selon l'une quelconque des revendications 5 à 7, dans lequel l'instant temporel caractéristique ($t_c$) est comparé à l'instant temporel de référence ($t_{ref}$) via une bascule (76) ou via un comparateur (86) avec une référence d'horloge ($t_{clock}$).

11. Circuit électronique (10) selon l'une quelconque des revendications 5 à 8, prise avec la revendication 4, dans lequel l'instant temporel de référence ($t_{ref}$) est obtenu via un ensemble de mêmes deuxièmes éléments (68) reliés entre eux et un ensemble de deuxièmes commutateurs (70), les deuxièmes éléments (68) étant les mêmes que ceux de l'ensemble du module de conversion (44), chaque deuxième élément (68) étant associé à la sortie d'une unité logique (42) respective, chaque deuxième commutateur (70) étant connecté en sortie d'une unité logique (42) respective et configuré pour activer, ou respectivement inhiber, le deuxième élément (68) correspondant selon la valeur haute ou basse en sortie de l'unité logique (42) respective, et chaque deuxième commutateur (70) étant commandé de manière inversée par rapport au commutateur (68) du module de conversion (44) qui est connecté en sortie de la même unité logique (42) respective ;
chaque deuxième élément (68) étant de préférence une résistance (88) ou un condensateur (63).

12. Circuit électronique (10) selon l'une quelconque des revendications précédentes, dans lequel chaque unité logique (42) réalise une fonction logique de type inverseur lors de l'opération de calcul.

13. Circuit électronique (10) selon l'une quelconque des revendications précédentes, dans lequel l'opération logique effectuée par l'unité logique (42) est une inversion, et l'opération de calcul est une opération de calcul neuronal, telle que l'opération MAC.

14. Circuit électronique (10) selon l'une quelconque des revendications précédentes, dans lequel le circuit électronique (10) est un circuit neuromorphique propre à mettre en oeuvre un réseau de neurones à sortie binaire, chaque cellule mémoire (12) étant associée à un poids synaptique respectif d'un neurone, et chaque paire de lignes de bits complémentaires étant apte à recevoir des tensions d'entrée complémentaires ($V_{in}$, $V_{inb}$) lors d'une opération de calcul neuronal.

15. Circuit électronique (10) selon l'une quelconque des revendications précédentes, comprenant un premier contrôleur (22) permettant de sélectionner les cellules mémoire (12) d'une rangée (18) qui sont reliées à une même ligne de mot (WL), et comprenant un deuxième contrôleur (24) relié aux paires de lignes de bit (BL, BLb) et permettant d'appliquer sur chaque paire de ligne de bit (BL, BLb) des tensions différentes et symétriques par rapport à une tension milieu, la tension appliquée sur une ligne de bit (BL) étant supérieure ou inférieur à celle appliquée sur la ligne de bit complémentaire (BLb) associée.

16. Circuit électronique (10) selon l'une quelconque des revendications précédentes, dans lequel le circuit électronique (10) comprend plusieurs ensembles distincts de cellules mémoire (12) propres à fonctionner en parallèle avec un même ensemble de paires de lignes de bit complémentaires (BL, BLb) et des ensembles distincts de lignes de mot (WL), chaque ensemble de cellules mémoire (12) étant relié à un ensemble respectif de lignes de mot.

17. Circuit électronique (10) selon l'une quelconque des revendications précédentes, dans lequel le circuit électronique (10) comprend plusieurs ensembles distincts de cellules mémoire (12) propres à fonctionner en parallèle avec un même ensemble de lignes de mot et des ensembles distincts de paires de lignes de bit complémentaires, chaque ensemble de cellules mémoire (12) étant relié à un ensemble respectif de paires de lignes de bit complémentaires ;

les dispositifs de lecture (16) de deux ensembles de cellules mémoire (12) successifs étant de préférence connectés entre eux via un interrupteur (102, 104),
l'interrupteur (102, 104) étant de préférence encore commandé en position fermée lors d'une opération de calcul neuronal pour effectuer ladite opération avec l'ensemble des tensions d'entrée complémentaires ($V_{in}$, $V_{inb}$) reçues par les deux ensembles de cellules mémoire (12).

**Patentansprüche**

1. Elektronische Schaltung (10), die geeignet ist, Rechenoperationen durchzuführen, die jeweils eine binäre Ausgabe bereitstellen, die Schaltung umfassend:

- Wortleitungen (WL);
- Paare komplementärer Bitleitungen (BL, BLb);
- Source-Leitungen (SL);
- eine Anordnung von Speicherzellen (12), die gemäß einer Matrix (14) organisiert sind, die Zeilen (18) und Spalten (20) aufweist, wobei die Speicherzellen (12) derselben Zeile (18) durch eine Wortleitung (WL) auswählbar sind, wobei die Speicherzellen (12) derselben Spalte (20) mit einem Paar komplementärer Bitleitungen (BL, BLb) und einer Source-Leitung (SL) verbunden sind;
jede Speicherzelle (12) umfassend zwei Memristoren und zwei Schalter, wobei jeder Memristor mit derselben Source-Leitung (SL) und mit einem jeweiligen Schalter verbunden ist, wobei jeder Memristor jeweils ein Gewicht oder das Inverse desselben Gewichts speichert, indem er jeweils einen ersten und einen zweiten unterschiedlichen Widerstandswert aufweist, wobei die Schalter zu ihrer Aktivierung mit einer jeweiligen Wortleitung (WL) verbunden sind und jeweils mit einem Paar komplementärer Bitleitungen (BL, BLb) verbunden sind;
- eine Lesevorrichtung (16), die bei jedem Rechenvorgang implementiert wird, wobei die Lesevorrichtung (16) Folgendes aufweist:

+ eine Logikeinheit (42) für jede Spalte (20), jede Logikeinheit (42) umfassend einen Eingangsanschluss, der mit einer jeweiligen Source-Leitung (SL) verbunden ist, um einen Eingangswert zu empfangen, wobei die Logikeinheit (42) konfiguriert ist, um eine logische Operation durchzuführen, die ein Umschalten zwischen einem niedrigen Wert und einem hohen Wert nur abhängig von dem Wert des Eingangs der Logikeinheit aufweist, die während der Rechenoperation mit der Source-Leitung (SL) verbunden ist, **dadurch gekennzeichnet, dass** die Lesevorrichtung (16) ferner Folgendes umfasst:

+ ein Umwandlungsmodul (44), das konfiguriert ist, um eine Anzahl von hohen oder niedrigen Werten am Ausgang der Logikeinheiten (42) in eine Zwischengröße umzuwandeln, die von der Anzahl von hohen oder niedrigen Werten am Ausgang der Logikeinheiten (42) abhängt, wobei die Zwischengröße eine elektrische Größe wie beispielsweise eine elektrische Spannung ist, deren Veränderung über die Zeit von einer Zeitkonstante (RC) abhängt, und der Wert der Zeitkonstante abhängig von der Anzahl von hohen oder niedrigen Werten am Ausgang der Logikeinheiten (42) ist, das Umwandlungsmodul (44) umfassend eine Anordnung gleicher, miteinander verbundener Elemente (62) und eine Anordnung von Schaltern (64), wobei jedes Element (62) mit dem Ausgang einer jeweiligen Logikeinheit (42) assoziiert ist, jeder Schalter (64) am Ausgang einer jeweiligen Logikeinheit (42) verbunden und konfiguriert ist, um das entsprechende Element (62) entsprechend dem hohen oder niedrigen Wert am Ausgang der jeweiligen Logikeinheit (42) jeweils zu aktivieren oder zu hemmen, und der Wert der Zeitkonstante von der Anzahl der aktivierten Elemente (62) abhängt, und
+ ein Vergleichsmodul (46), das konfiguriert ist, um die Zwischengröße mit einer Referenzgröße zu vergleichen und ein digitales Ein-Bit-Signal zu emittieren, das von dem Vergleich abhängt und dem Ausgang der elektronischen Schaltung (10) entspricht, wobei das emittierte Signal repräsentativ für das Resultat der Rechenoperation ist.

2. Elektronische Schaltung (10) nach Anspruch 1, wobei der Wert der Zeitkonstante direkt proportional zu der Anzahl der hohen oder niedrigen Werte am Ausgang der Logikeinheiten (42) ist.

3. Elektronische Schaltung (10) nach einem der vorherigen Ansprüche, wobei der Wert der Zeitkonstante gleich wie das Produkt aus einer Kapazität und einem Widerstand ist, wobei eines von Kapazität und Widerstand vordefiniert ist und das andere von der Anzahl der hohen oder niedrigen Werte am Ausgang der Logikeinheiten (42) abhängt.

4. Elektronische Schaltung (10) nach einem der vorherigen Ansprüche, wobei jedes Element (62) ein Widerstand (88) oder ein Kondensator (63) ist.

5. Elektronische Schaltung (10) nach einem der vorherigen Ansprüche, wobei die Gesamtheit derselben Elemente zwischen einem ersten Versorgungspotential ($V_{DD}$, GND) und einem Zwischenknoten ($V_{pop}$) platziert ist, und das Umwandlungsmodul (44) ferner ein komplementäres Element aufweist, das zwischen dem Zwischenknoten ($V_{pop}$) und einem zweiten Versorgungspotential (GND; $V_{DD}$) platziert ist.

6. Elektronische Schaltung (10) nach den Ansprüchen 4 und 5, wobei wenn jedes Element (62) ein Kondensator (63) ist, das komplementäre Element ein Widerstand (65) ist;
wobei wenn jedes Element (62) ein Widerstand (88) ist, das komplementäre Element ein Kondensator (92) ist.

7. Elektronische Schaltung (10) nach einem der vorherigen Ansprüche, wobei das Vergleichsmodul (46) konfiguriert ist, um die Zwischengröße in ein Rechtecksignal mit einer Zustandsänderungsflanke zu einem charakteristischen Zeitpunkt ($t_c$) umzuwandeln, wobei der charakteristische Zeitpunkt ($t_c$) dann mit einem Referenzzeitpunkt ($t_{ref}$) verglichen wird, der mit der Referenzgröße assoziiert ist, und das Signal, das repräsentativ für das Resultat der Rechenoperation ist, dann von diesem Vergleich abhängt.

8. Elektronische Schaltung (10) nach Anspruch 5, wobei die Zwischengröße über einen Komparator (72) in ein Rechtecksignal umgewandelt wird.

9. Elektronische Schaltung (10) nach Anspruch 6, wobei das Vergleichsmodul (46) den Komparator (72) und einen Vergleichsspannungsgenerator ($V_{comp}$) umfasst, und der Komparator (72) geeignet ist, um die erzeugte Spannung mit der Vergleichsspannung aus dem Vergleichsspannungsgenerator zu vergleichen.

10. Elektronische Schaltung (10) nach einem der Ansprüche 5 bis 7, wobei der charakteristische Zeitmoment ($t_c$) mit dem Referenzzeitmoment ($t_{ref}$) über ein Flipflop (76) oder über einen Komparator (86) mit einer Taktreferenz ($t_{clock}$) verglichen wird.

11. Elektronische Schaltung (10) nach einem der Ansprüche 5 bis 8 in Verbindung mit Anspruch 4, wobei der Referenzzeitpunkt ($t_{ref}$) über eine Anordnung gleicher zweiter Elemente (68), die miteinander verbunden sind, und eine Anordnung zweiter Schalter (70) erlangt wird, wobei die zweiten Elemente (68) gleich sind wie die des gesamten Umwandlungsmoduls (44), wobei jedes zweite Element (68) mit dem Ausgang einer jeweiligen Logikeinheit (42) verbunden ist, jeder zweite Schalter (70) mit dem Ausgang einer jeweiligen Logikeinheit (42) verbunden und konfiguriert ist, um das entsprechende zweite Element (68) entsprechend dem hohen oder niedrigen Wert am Ausgang der jeweiligen Logikeinheit (42) jeweils zu aktivieren oder zu deaktivieren, und jeder zweite Schalter (70) in Bezug auf den Schalter (68) des Umwandlungsmoduls (44), der mit dem Ausgang der gleichen jeweiligen Logikeinheit (42) verbunden ist, invers gesteuert wird;
wobei jedes zweite Element (68) vorzugsweise ein Widerstand (88) oder ein Kondensator (63) ist.

12. Elektronische Schaltung (10) nach einem der vorherigen Ansprüche, wobei jede Logikeinheit (42) während der Rechenoperation eine logische Funktion vom Typ Inverter realisiert.

13. Elektronische Schaltung (10) nach einem der vorherigen Ansprüche, wobei die von der Logikeinheit (42) ausgeführte logische Operation eine Inversion ist und die Rechenoperation eine neuronale Operation wie beispielsweise die MAC-Operation ist.

14. Elektronische Schaltung (10) nach einem der vorherigen Ansprüche, wobei die elektronische Schaltung (10) eine neuromorphe Schaltung ist, die geeignet ist, ein neuronales Netz mit binärem Ausgang zu implementieren, wobei jede Speicherzelle (12) mit einem jeweiligen synaptischen Gewicht eines Neurons assoziiert ist und jedes Paar komplementärer Bitleitungen geeignet ist, bei einer neuronalen Rechenoperation komplementäre Eingangsspannungen ($V_{in}$, $V_{inb}$) zu empfangen.

15. Elektronische Schaltung (10) nach einem der vorherigen Ansprüche, umfassend eine erste Steuerung (22) zum Auswählen von Speicherzellen (12) in einer Reihe (18), die mit derselben Wortleitung (WL) verbunden sind, und eine zweite Steuerung (24), die mit den Bitleitungspaaren (BL, BLb) verbunden ist und es ermöglicht, an jedes Paar von Bitleitungen (BL, BLb) unterschiedliche Spannungen anzulegen, die symmetrisch zu einer mittleren Spannung sind, wobei die an eine Bitleitung (BL) angelegte Spannung höher oder niedriger ist als jene, die an die assoziierte komplementäre Bitleitung (BLb) angelegt wird.

16. Elektronische Schaltung (10) nach einem der vorherigen Ansprüche, wobei die elektronische Schaltung (10) mehrere separate Anordnungen von Speicherzellen (12) umfasst, die geeignet sind, parallel mit derselben Anordnung von Paaren komplementärer Bitleitungen (BL, BLb) und separaten Anordnungen von Wortleitungen (WL) betrieben zu werden, wobei jede Anordnung von Speicherzellen (12) mit einer jeweiligen Anordnung von Wortleitungen verbunden ist.

17. Elektronische Schaltung (10) nach einem der vorherigen Ansprüche, wobei die elektronische Schaltung (10) mehrere separate Anordnungen von Speicherzellen (12) umfasst, die geeignet sind, parallel mit derselben Anordnung von Wortleitungen und mit separaten Anordnungen Sätzen von Paaren komplementärer Bitleitungen betrieben zu werden, wobei jede Anordnung von Speicherzellen (12) mit einer jeweiligen Anordnung von Paaren komplementärer Bitleitungen verbunden ist;

wobei die Lesevorrichtungen (16) von zwei aufeinanderfolgenden Anordnung von Speicherzellen (12) vorzugsweise über einen Schalter (102, 104) miteinander verbunden sind,

wobei der Schalter (102, 104) bei einer neuronalen Rechenoperation vorzugsweise noch in der geschlossenen Position gesteuert wird, um die Operation mit der gesamten Anordnung der komplementären Eingangsspannungen ($V_{in}$, $V_{inb}$) durchzuführen, die von den zwei Anordnungen von Speicherzellen (12) empfangen werden.

## Claims

1. An electronic circuit (10) suitable for implementing computing operations each providing a binary output, the circuit comprising:

   - word lines (WL);
   - pairs of complementary bit lines (BL, BLb);
   - source lines (SL);
   - a set of memory cells (12) organized according to a matrix (14) including rows (18) and columns (20), the memory cells (12) of a same row (18) being selectable by a word line (WL), the memory cells (12) of a same column (20) being connected to a pair of complementary bit lines (BL, BLb) and to a source line (SL);
   each memory cell (12) comprising two memristors and two switches, each memristor being connected to the same source line (SL) and to a respective switch, each memristor respectively storing a weight or the inverse of the same weight by respectively presenting first and second different resistance values; the switches being connected, for their activation, to a respective word line (WL) and connected respectively to a pair of complementary bit lines (BL, BLb);
   - a reading device (16) implemented during each calculation operation, the reading device (16) comprising:

     + a logic unit (42) for each column (20), each logic unit (42) comprising an input terminal connected to a respective source line (SL) for receiving an input value, the logic unit (42) being configured to perform a logic operation presenting a switching between a low value and a high value depending solely on the value of the input of the logic unit which is connected to the source line (SL) during said calculation operation,

     **characterized in that** the reading device (16) further includes:

     + a conversion module (44) configured to convert a number of high or low values at the output of the logic units (42) into an intermediate value dependent on said number of high or low values at the output of the logic units (42), the intermediate value is an electrical value, such as an electrical voltage, the variation of which over time depends on a time constant (RC), and the value of the time constant is a function of the number of high or low values at the output of the logic units (42), the conversion module (44) including a set of same elements (62) connected together and a set of switches (64), each element (62) being associated with the output of a respective logic unit (42), each switch (64) being connected to the output of a respective logic unit (42) and configured to activate, or respectively inhibit, the corresponding element (62) according to the high or low value at the output of the respective logic unit (42), and the value of the time constant depending on the number of elements (62) activated, and

     + a comparison module (46) configured to compare the intermediate value with a reference value and to output a one-bit digital signal, depending on the comparison and corresponding to the output of the electronic circuit (10), the output signal being representative of the result of the calculation operation.

2. The electronic circuit (10) according to claim 1, wherein the value of the time constant is directly proportional to the number of high or low values at the output of the logic units (42).

3. The electronic circuit (10) according to any one of the preceding claims, wherein the value of the time constant is equal to the product of a capacitance and a resistance, one from among the capacitance and the resistance being predefined, and the other from among the capacitance and the resistance depending on the number of high or low values at the output of the logic units (42).

4. The electronic circuit (10) according to any one of the preceding claims, wherein each element (62) is a resistor (88) or a capacitor (63).

5. The electronic circuit (10) according to any one of the preceding claims, wherein the set of same elements is placed between a first supply potential ($V_{DD}$; GND) and an intermediate node ($V_{pop}$), and the conversion module (44) further includes a complementary element placed between the intermediate node ($V_{pop}$) and a second supply potential (GND; $V_{DD}$).

6. The electronic circuit (10) according to claims 4 and 5, wherein when each element (62) is a capacitor (63), the complementary element is a resistor (65);
wherein when each element (62) is a resistor (88), the complementary element is a capacitor (92).

7. The electronic circuit (10) according to any one of the preceding claims, wherein the comparison module (46) is configured to transform the intermediate value into a square-wave signal with a change-of-state edge at a characteristic time instant ($t_c$), the characteristic time instant ($t_c$) then being compared with a reference time instant ($t_{ref}$) associated with the reference value, and the signal representative of the result of the calculation operation then depending on said comparison.

8. The electronic circuit (10) according to claim 5, wherein the intermediate value is transformed into the square-wave signal via a comparator (72).

9. The electronic circuit (10) according to claim 6, wherein the comparison module (46) includes the comparator (72) and a comparison voltage generator ($V_{comp}$), and the comparator (72) is able to compare the generated voltage with the comparison voltage coming from the comparison voltage generator.

10. The electronic circuit (10) according to any one of claims 5 to 7, wherein the characteristic time instant ($t_c$) is compared with the reference time instant ($t_{ref}$) via a flip-flop (76) or via a comparator (86) with a clock reference ($t_{clock}$).

11. The electronic circuit (10) according to any one of claims 5 to 8, taken together with claim 4, wherein the reference time instant ($t_{ref}$) is obtained via a set of the same second elements (68) connected together and a set of the second switches (70), the second elements (68) being the same as those of the conversion module assembly (44), each second element (68) being associated with the output of a respective logic unit (42), each second switch (70) being connected to the output of a respective logic unit (42) and configured to activate, or respectively inhibit, the corresponding second element (68) according to the high or low value at the output of the respective logic unit (42), and each second switch (70) being controlled inversely relative to the switch (68) of the conversion module (44) which is connected to the output of the same respective logic unit (42);
each second element (68) preferably being a resistor (88) or a capacitor (63).

12. The electronic circuit (10) according to any one of the preceding claims, wherein each logic unit (42) performs an inverter-type logic function during the calculation operation.

13. The electronic circuit (10) according to any one of the preceding claims, wherein the logic operation performed by the logic unit (42) is an inversion, and the operation is a neural calculation operation, such as the MAC operation.

14. The electronic circuit (10) according to any one of the preceding claims, wherein the electronic circuit (10) is a neuromorphic circuit able to implement a neural network with binary output, each memory cell (12) being associated with a respective synaptic weight of a neuron, and each pair of complementary bit lines being able to receive complementary input voltages ($V_{in}$,$V_{inb}$) during a neural calculation operation.

15. The electronic circuit (10) according to any one of the preceding claims, comprising a first controller (22) allowing to select the memory cells (12) of a row (18) which are connected to a same word line (WL), and comprising a second controller (24) connected to the pairs of bit lines (BL, BLb) and allowing different voltages to be applied to each pair of bit lines (BL, BLb) which are symmetrical relative to a midpoint voltage, the voltage applied to a single bit line (BL) being greater or less than that applied to the associated complementary bit line (BLb).

16. The electronic circuit (10) according to any one of the preceding claims, wherein the electronic circuit (10) comprises a plurality of distinct sets of memory cells (12) able to operate in parallel with a same set of pairs of complementary bit lines (BL, BLb) and distinct sets of word lines (WL), each set of memory cells (12) being connected to a respective set of word lines.

17. The electronic circuit (10) according to any one of the preceding claims, wherein the electronic circuit (10) comprises a plurality of distinct sets of memory cells (12) able to operate in parallel with a same set of word lines and distinct sets of pairs of complementary bit lines, each set of memory cells (12) being connected to a respective set of pairs of complementary bit lines;

the reading devices (16) of two successive sets of memory cells (12) being preferably connected to each other via a switch (102, 104),
the switch (102, 104) being preferably further controlled to the closed position during a neural calculation operation to perform said operation with the set of complementary input voltages ($V_{in}$, $V_{inb}$) received by the two sets of memory cell (12).

FIG.1

WL$_i$

32G    32D    34D    12    34G

32S    32    28    30    34    34S

BL$_j$    SL$_j$    BLb$_j$

## FIG.2

FIG.3

FIG.4

**FIG.5**

FIG.6

$$XNOR(w_1,x_1) \quad XNOR(w_2,x_2) \quad XNOR(w_n,x_n)$$

## FIG.7

FIG.8

FIG.9

## FIG.10

FIG.11

$$V_{comp} = \frac{V_{DD}}{2}$$

# FIG.12

## FIG.13

$$t_{clock} = \frac{n}{2}\ln(2)RC_O$$

$$t_{clock} = \left(\frac{n}{2}+B\right)\ln(2)RC_O$$

## FIG.14

## FIG.15

FIG.16

EP 4 576 094 B1

FIG.17

EP 4 576 094 B1

## FIG.18

# EP 4 576 094 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2023059091 A1

- EP 4137999 A1

**Littérature non-brevet citée dans la description**

- **W. WAN et al.** A compute-in-memory chip based on resistive random-access memory. *Nature*, 2022
- **L. WANG et al.** *Efficient and Robust Nonvolatile Computing-In-Memory Based on Voltage Division in 2T2R RRAM With Input-Dependent Sensing Controf*, May 2021

- **S. JUNG et al.** A crossbar array of magnetoresistive memory devices for in-memory computing. *Nature*, 2022
- **M. EZZADEEN et al.** *Low-Overhead Implementation of Binarized Neural Networks Employing Robust 2T2R Resistive RAM Bridges*, September 2021